# EUROPEAN PATENT APPLICATION

(11) **EP 1 796 144 A1**
(43) Date of publication of application: **13.06.2007**
(21) Application number: 05780340.5
(22) Date of filing: 19.08.2005
(51) Int. Cl.: H01L 21/027, G03F 7/20, H01L 21/68

(54) **STAGE APPARATUS AND EXPOSURE APPARATUS**

(30) Priority: 24.08.2004 JP 2004244397
(71) Applicant: NIKON CORPORATION, Tokyo 100-8331 (JP)
(72) Inventor: EBIHARA, Akimitsu, NIKON CORPORATION, Tokyo 100-8331 (JP)
(74) Representative: Bergstrand, Mikael Gudmundsson
(86) International application number: PCT/JP2005/015128
(87) International publication number: WO 2006/022200

(57) **Abstract**

A stage apparatus wherein a movable part, which holds an object and is driven along a guide member, is reduced in sizes and weight, and vibration caused while the movable part is being driven is not easily transmitted to the object. The stage apparatus is provided with a Y axis guide (33Y) and an X axis guide (33X) arranged to orthogonally intersect each other at the upper part of a guide plane (31a); a Y axis slider (39) and an X axis slider (40) which move along the guides; and a wafer stage (WST) connected to the Y axis slider (39) and the X axis slider (40) to hold a wafer (W). The Y axis slider (39) and the X axis slider (40) are connected by a connecting member having a flexible structure.

## Description

### Technical Field

The present invention relates to a stage apparatus for driving an object. Further, the present invention also relates to an exposing apparatus used for transferring a predetermined pattern onto a substrate when various devices such as a semiconductor device and a liquid crystal display are produced.

### Background Art

In a lithography step which is one of producing steps of a semiconductor device, an exposing apparatus is used for transferring a pattern formed on a reticle (or photomask) as a mask on a wafer (such as a glass plate) as a substrate on which a photoresist is applied, and for exposing the pattern. As the exposing apparatus, a full field exposing type (static exposing type) projection exposing apparatus like a stepper, or a scanning exposing type projection exposing apparatus (scanning type exposing apparatus) like a scanning stepper is used.

In such exposing apparatuses, a structure of a stage apparatus which positions and moves a reticle or a wafer largely influences apparatus performance such as vibration isolation performance and exposing precision (positioning precision or the like), and producing cost of the exposing apparatus. Of conventional stage apparatuses, one example of a wafer stage system which positions and moves a wafer includes two parallel first guide members, a second guide member which is driven along the first guide members by a driving device such as a linear motor, and a movable stage which has high rigidity, which holds the wafer, and which is driven along the second guide member by a driving device such as a linear motor (e.g., see patent document 1).

In order to reduce vibration generated from the stage apparatus and to enhance the exposing precision, there is also developed a counter balance type stage apparatus which can move a guide member of the stage apparatus (e.g., see patent document 1). In this stage apparatus, when another guide member or a movable stage is to be driven along the guide member, the guide member moves in the opposite direction such as to satisfy the conservation of momentum or to offset the driving reaction.
[Patent Document 1] International Patent Application Publication Laid-open No.01/47001

### Disclosure of the Invention

### Problem to be Solved by the Invention

In the conventional wafer stage system, as described above, a wafer was held by the movable stage which was driven along the guide member. In other words, a slider which is driven along the guide member and a movable element of the driving device were integrally incorporated in the movable stage. Therefore, it was difficult to reduce the movable stage including expensive member having high rigidity in size and weight, the producing cost of the exposing apparatus was high, and in order to enhance the driving speed of the movable stage, it was necessary to increase the output of the driving device. When the movable stage was driven along the guide member, vibration generated in the driving device was easily transferred to the wafer, and this vibration caused a problem when the exposing precision was to be further enhanced.

A mechanism ("Z leveling mechanism", hereinafter) for controlling a height of the wafer and an inclination angle around two intersecting shafts is incorporated in the movable stage. However, if the slider and the movable element were integrally incorporated in the movable stage, there was a problem that constraint of a structure of the Z leveling mechanism was great.
When the guide member is made movable in the counter balance manner so as to reduce the influence of vibration generated by the stage apparatus, another driving device for driving this guide member is required to prevent the position of the guide member from deviating gradually. For this reason, the structure of the stage apparatus became complicated, and there was a problem that the producing cost of the exposing apparatus was increased.

In view of the above circumstances, it is a first object of the present invention to provide a stage apparatus in which a movable section which holds an object and can drive along a guide member can be reduced in size and weight, and vibration caused when the movable section is driven is not easily transmitted to the object.
It is a second object of the invention to provide a stage apparatus in which a movable section which holds an object can be driven along a guide member by a driving device, a mechanism for controlling the height of the object can easily be incorporated into the stage apparatus, and vibration isolation performance of the stage apparatus is excellent.

It is a third object of the invention to provide a stage apparatus capable of reducing influence of reaction caused when the movable section is driven, and capable of suppressing vibration with a relatively simple structure.
It is another object of the invention to provide an exposing apparatus having such a stage apparatus and in which vibration isolation performance or apparatus performance (exposing precision and the like) are improved.

### Means for Solving Problem

A first stage apparatus according to the present invention which drives an object includes: a base member; a first guide member disposed along a guide face of the base member; a second guide member disposed along the guide surface so as to intersect with the first guide member; first and second sliders disposed such that the first and second sliders can move along the first and second guide members, respectively; a connecting member having a flexible structure to connect the first and second sliders to each other; and a movable stage which is to hold the object and is movably disposed on the guide face, and which is connected to the first and second sliders.

According to the present invention, the first and second sliders are connected to each other via the connecting member of the flexible structure. The member of the flexible structure can be made small and light-weighted. Therefore, according to the present invention, the movable section (including the two sliders, the movable stage and connecting members thereof) can be reduced in weight in a state in which necessary rigidity is obtained as compared with a case in which the two sliders are integrally formed together. Further, the mechanical mutual interference between the two sliders is reduced. Thus, vibration generated in one of the sliders is not easily transmitted to the other slider, vibration caused when the sliders are driven is not easily transmitted to the object, and the vibration isolation characteristics are enhanced.

In other words, according to the present invention, a ratio of rigid structure occupying the device is reduced, and the flexible structure is employed. Generally, the flexible structure has the opposite characteristics from those of the rigid structure, the flexible structure is light in weight and inexpensive, and it is possible to obtain preferable characteristics that vibration is isolated and the flexible structure is not damaged by thermal displacement depending upon the flexible structure. In the present invention, the rigid structure can be used in a portion which exerts influence directly on the apparatus performance, and the flexible structure can be used in a portion where transmission of vibration should be shut off and influence of thermal displacement should be shut off, or a portion where rigid structures are connected to each other. Therefore, the mechanism can be reduced in weight while maintaining the apparatus performance at high level.

In the present invention, the connecting member includes a rod member having a flexure mechanism as one example. Such a rod member can easily be produced and incorporated.
As one example, the first and second sliders are cylindrical members mounted on the first and second guide members. With this, these sliders stably move along the respective guide members.

The stage apparatus may further include first and second drive mechanisms which respectively drive the first and second guide members in directions intersecting with each other, and a fine motion mechanism which finely moves at least a portion of the movable stage with respect to the first and second sliders. The drive mechanism of the guide member can be regarded as a coarse motion mechanism. When the guide members are driven in the intersecting two directions in this manner, since it is unnecessary to incorporate the coarse motion mechanism into the slider, the movable section can further be reduced in weight. The remaining positioning error and synchronizing error at the time of scanning and exposing operation can be corrected quickly.

The first and second guide members may be of hollow structures. With this, the movable section can further be reduced in weight.
Next, a second stage apparatus of the present invention which drives an object includes: a base member; a guide member disposed along a guide face of the base member; a slider disposed such that the slider can move along the guide member; a movable stage which is to hold the object and can move in a direction intersecting with the guide face; and a connecting member having a flexible structure to connect the slider and the movable stage.

According to the present invention, the slider and the movable stage are connected to each other via the connecting member of the flexible structure. Therefore, a ratio of rigid structure occupying the device is reduced, and the movable section can be reduced in weight. Vibration of the drive mechanism (coarse motion mechanism) which drives the slider along the guide member is isolated by the connecting member, and the influence of thermal displacement is reduced.

It is possible to hold the object and move in the direction intersecting with the guide surface. This means that the height (position of the guide surface in the normal direction of the object) of the object and the inclination angle thereof can be controlled. According to the invention, the mechanism which controls the height and inclination angle thereof can easily be incorporated by connecting the mechanism to the slider.
In the present invention, as one example, the movable stage includes three drive members which drive to positions in directions intersecting with the guide face independently of each other, and a table section which is to hold the object supported by the three drive members, and the connecting member connects the slider and two of the three drive members.

Since the device includes the three drive members, the height of the object and the inclination angle around two axes which intersect with each other at a right angle can be controlled. The slider is connected to these drive members via the connecting member of the flexible structure. With this, stress or mutual interference between the drive members and the slider can be reduced, and the mechanism which controls the height and inclination angle of the object can be incorporated more easily.
As one example, the table section is supported in a floating manner above the drive member via a gas layer by a gas bearing mechanism incorporated in the drive member. When vibration from the floor is transmitted to the stage apparatus via the base member, if the three drive members are controlled such as to offset the vibration, the vibration isolation performance is enhanced.

The three drive members may be connected to each other via a connecting mechanism having a structure more flexible than the drive members. With this, deformation stress is reduced, and the movable section can further be reduced in weight.
The table section may be made of a material having a specific rigidity higher than that of the guide member. The specific rigidity is a value obtained by dividing rigidity by weight of unit volume. A material having a high specific rigidity is light in weight and has high rigidity. One example of materials having a high specific rigidity is ceramic, and a material having a specific rigidity lower than ceramic is aluminum. The object is held by the table section. Therefore, if the rigidity of the table section is enhanced, it is possible to position the object precisely, and since the table section is light in weight, the positioning thereof can be carried out quickly. Although a material having a high specific rigidity is relatively expensive, but if a material having a low specific rigidity is used for the guide member, the producing cost can be reduced. In such a case, it is preferable to precisely measure the coordinates of the table section using a laser interferometer or the like.

The stage apparatus may further includes a drive mechanism which drives the guide member along the guide face, and a fine motion mechanism which finely moves at least a portion of the movable stage with respect to the slider. By driving the guide member, the slider can be reduced in size and weight, the remaining positioning error and synchronizing error can be corrected quickly by driving the table section of the movable stage with respect to the slider by the fine motion mechanism.

A third stage apparatus of the present invention which drives an object includes: a base member mounted on an installation face; a movable stage which is to hold the object and which is movably disposed on a guide face of the base member; a driving device which drives the movable stage, the driving device including a movable element connected to the movable stage and a stator which is movably supported; a frame which is provided independently of the base member and which receives a reaction force generated when the movable stage is driven; a mass body which is disposed between the stator and the frame and which can move; a first connecting member which connects the stator and the mass body; and a second connecting member which connects the mass body and the frame.

According to the present invention, a reaction force applied to the stator when the movable stage (movable section) is driven is transmitted to the installation face via the mass body and the frame. At that time, since the mass body can move, high frequency component of the reaction force is attenuated by the mass body, and mainly low frequency component of the reaction force is transmitted to the installation surface. The attenuation effect of the installation surface with respect to the vibration of low frequency is high. Since the frame is stationary, the position of the stator is not gradually largely deviated, and a drive mechanism which returns the position of the stator to a neutral position side can be omitted. Therefore, using the relatively simple structure, it is possible to reduce the influence of the reaction force caused when the movable section is driven.

In the present invention, the stator may be disposed on the base member. In this case, the stator can be fixed via a resilient member having resiliency such as a leaf spring. With this, the position of the stator is not varied almost at all and thus, the stator can be reduced in size.
As one example, the mass body may be disposed on the base member. As another example, the mass body may be disposed on a member which is different from the base member, or on the installation face.

At least one of the first and second connecting members can include a coil spring. A high frequency component of the reaction force caused when the movable stage is driven can be attenuated by the coil spring and the mass body.
As one example, the mass of the stator is heavier than the mass of the mass body. With this, a mechanism which reduces the reaction force can be reduced in size.

The stators are disposed at two locations so as to sandwich the movable stage, and the stators at the two locations may be connected via a connecting member. With this, reaction forces applied to the stators at the two locations can be averaged.
Next, a fourth stage apparatus of the present invention which drives an object, includes: a base member; a hollow guide member disposed along a guide face of the base member; a slider disposed such that the slider can move along the guide member; and a movable stage which is to hold the object and is disposed on the guide face such that the movable stage can move, and which is connected to the slider.

According to the present invention, the guide member can be regarded as a light member of a flexible structure.
Therefore, as one example, when the slier and the movable stage are driven by driving the guide member, the movable section can be reduced in weight. Since the guide member is of the flexible structure, vibration caused when the guide member is driven is not easily transmitted to the object.
Next, a fifth stage apparatus of the present invention which drives an object, includes: a base member; a movable stage which is to hold the object and which can move on the base member; a first guide member which is disposed on a guide face of the base member along a first side face of the movable stage; a first slider movably disposed along the first guide member; and a first driving device which drives the movable stage in a first direction, the first driving device including a first stator provided at the first slider, a first moving element provided at the movable stage.

According to the present invention, since the guide member is disposed on the side face of the movable stage, the movable stage (movable section) can be reduced in size and weight. Since the movable stage is driven from the side face, vibration caused at the time of driving is not easily transmitted to the object.
In the present invention, as one example, the first moving element is provided on the first side face.
The stage apparatus may includes: a second guide member disposed on a guide face of the base member along a second side face which intersects with the first side face of the movable stage at a right angle; a second slider disposed such that the second slider can move along the second guide member, and a second driving device which drives the movable stage in a second direction intersecting with the first direction at a right angle, the second driving device including a second stator provided at the second slider, a second movable element provided at the movable stage.
The second movable element may be provided on the second side face.
The stage apparatus may include a third driving device which is connected to the first slider and which drives the movable stage in a direction intersecting with the guide surface.
The stage apparatus may include a third driving device which is connected to the second slider and which drives the movable stage in a direction intersecting with the guide surface.

The stage apparatus may include a fourth driving device which drives the first guide member in the first direction.
The stage apparatus may include a fifth driving device which drives the second guide member in the second direction.
Next, in an exposing apparatus of the present invention, a pattern is transferred and exposed onto a substrate via a projection system, and a substrate is driven using any one of stage apparatuses of the present invention.
The stage apparatus of the present invention includes a flexible structure or a movable mass body. The movable section can be reduced in weight or influence of vibration can be reduced. Therefore, according to the exposing apparatus of the present invention, the producing cost can be reduced, the vibration isolation performance can be enhanced, and the apparatus performance (exposing precision or the like) can be enhanced.

### Effect of the Invention

According to the first, second and fifth stage apparatuses of the present invention, since the rigid structure and the flexible structure can be combined, the movable section can be reduced in size and weight, vibration caused when the movable section is driven is not easily transmitted to the object, and the vibration isolation performance is excellent.
In the invention of the second stage, when two of the three drive members and the slider are connected to each other, a mechanism for controlling the height of the object and the like can easily be incorporated.

According to the third stage apparatus of the present invention, influence of the reaction force caused when the movable section is driven can be reduce and vibration can be suppressed with a relatively simple structure.
According to the fourth stage apparatus of the present invention, since the device has the hollow guide member, the movable section can be reduced in weight and the vibration isolation performance can be enhanced.

### Brief Description of the Drawings

FIG. 1 is a diagram showing an outline structure of a projection exposing apparatus of an embodiment of the present invention.
FIG. 2 is a perspective view showing a wafer stage system of the projection exposing apparatus of a first embodiment of the present invention.
FIG. 3 is a perspective view corresponding to FIG. 2 from which a wafer table WTB is removed.
FIG. 4 is a partially cut-away side view showing a wafer stage WST and a Y-axis slider 39 shown in FIG. 2.
FIG. 5(A) is a plan view showing the wafer table WTB shown in FIG. 2, and FIG. 5(B) is a side view showing an actuator 54X and an end of the wafer table WTB shown in FIG. 2.
FIG. 6 is an enlarged view showing a flat plate-like flexure 41A shown in FIG. 3.
FIG. 7 is a perspective view of an essential portion showing a mounting state of stators of actuators 53XA to 53YB with respect to sliders 39 and 40 and a connecting state of a Z leveling mechanism 55 with respect to the sliders 39 and 40.
FIG. 8 is a perspective view corresponding to FIG. 2 from which a mechanism of a stator of a coarse motion mechanism and the wafer stage WST are removed.
FIG. 9 is a partially cut-away perspective view showing a positional relationship between a Y-axis guide 33Y, an X-axis guide 33X, a Y-axis slider 39 and an X-axis slider 40 shown in FIG. 2.
FIG. 10(A) is a perspective view showing a connected state between the Y-axis slider 39 and the X-axis slider 40, and FIG. 10(B) is an enlarged view showing a rod 58A shown in FIG. 10(A).
FIG. 11(A) is a perspective view showing one example of a structure of the X-axis guide 33X shown in FIG. 2, and FIG. 11(B) is a perspective view showing another example of the structure of the X-axis guide 33X.
FIG. 12 is a schematic view of members from a linear motor 44XA to a frame member 43C shown in FIG. 2.
FIG. 13 show one example of a simulation result of thrust of the linear motor and displacement of related members when a mechanism shown in FIG. 12 is used.
FIG. 14 shows a mechanism of a modification of FIG. 12.
FIG. 15 show one example of a simulation result of thrust of the linear motor and displacement of related members when a mechanism shown in FIG. 14 is used.
FIG. 16(A) is a plan view of an outline structure of a wafer stage system of a projection exposing apparatus according to a second embodiment of the invention, and FIG. 16(B) is a plan view showing a state in which a wafer table WTB is moved from the state shown in FIG. 16(A).
FIG. 17 is a front view of an essential portion showing a positional relationship between a projection optical system PL and a wafer stage system in the state shown in FIG. 16(B).
FIG. 18 is a perspective view showing an outline structure of a wafer stage system of a projection exposing apparatus of a third embodiment of the invention.

### Explanation of Symbols

R ... reticle, W ... wafer, PL ... projection optical system, WST ... wafer stage, WTB ... wafer table, 31 ... wafer base, 31a ... guide surface, 33Y ... Y-axis guide, 33X ... X-axis guide, 39 ... Y-axis slider, 40 ... X-axis slider, 41A, 41B ... flat plate-like flexure, 43C ... frame member, 44XA, 44XB, 44YA, 44YB ... linear motor, 47A to 47D ... damper member, 46A to 46D, 50A, 50B ... coil spring, 53XA, 53XB, 53YA, 53YB ... voice coil motor type actuator, 54X, 54Y ... EI core type actuator, 55 ... Z leveling mechanism, 56A to 56C ... Z-axis actuator, 58A, 58B ... rod

### Best Mode for Carrying Out the Invention

### [First embodiment]

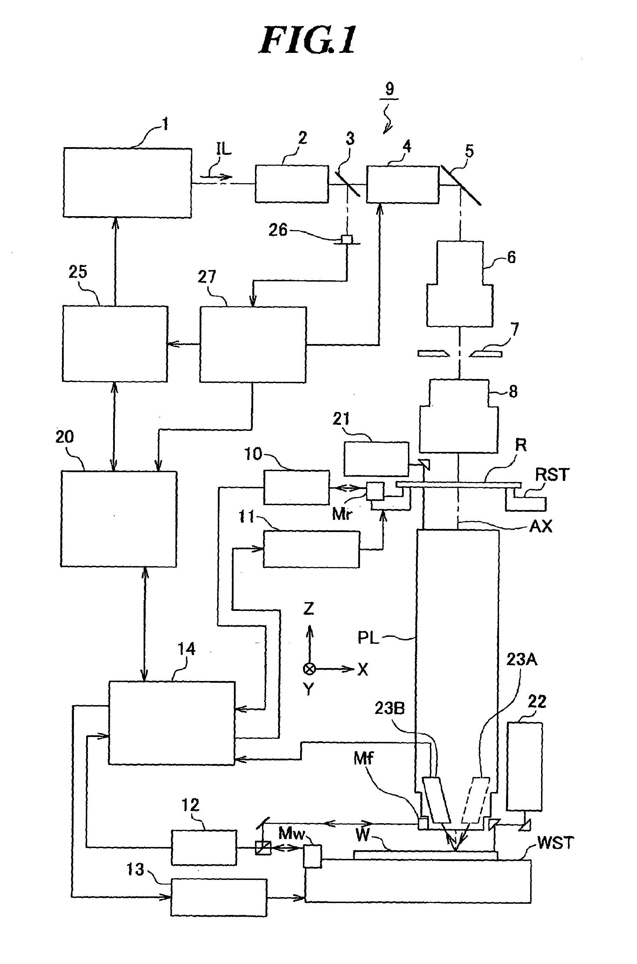

Preferred embodiments of the present invention will be explained with reference to FIGS. 1 to 15 . In the embodiments, the invention is applied to a full field exposing type projection exposing apparatus such as a stepper, and to a scanning exposing type projection exposing apparatus like a scanning stepper.
FIG. 1 is a block diagram of function units constituting a projection exposing apparatus as an exposing apparatus of the embodiment. In FIG. 1, a chamber for accommodating the projection exposing apparatus is omitted. In FIG. 1, a laser light source 1 including a KrF excimer laser (wavelength: 248 nm) or an ArF excimer laser (wavelength: 193 nm) is used as an exposing light source. It is also possible to use, as the exposing light source, a light source which emits laser light in ultraviolet region in lasing stage such as an F2 laser (wavelength: 157 nm), a light source which emits high harmonic laser light in vacuum ultraviolet region obtained by converting laser light in near-infrared region from a solid-state laser light source (YAG or a semiconductor laser) in wavelength, and a mercury discharge lamp which is frequently used in the exposing apparatus of this kind.

A reticle blind mechanism 7 is irradiated with exposing illumination light IL as exposure beam (exposure light) from a laser light source 1 via a homogenizing optical system 2 comprising a lens system and a fly-eye lens system, a beam splitter 3, a variable beam attenuator 4 for adjusting light quantity, a mirror 5 and a relay lens system 6 with uniform illumination distribution. A reticle R as a mask is irradiated with illumination light IL which is limited to a predetermined shape (rectangle in the case of full field exposing type, and slit shape in the case of scanning exposing type) via an image forming lens system 8, and an image of an opening of the reticle blind mechanism 7 is formed on the reticle R. An illumination optical system 9 comprises the homogenizing optical system 2, the beam splitter 3, the variable beam attenuator 4, the mirror 5, the relay lens system 6, the reticle blind mechanism 7 and the image forming lens system 8.

An image of a portion of a circuit pattern region (pattern) formed on the reticle R which is irradiated by the illumination light is formed and projected on a wafer W to which a resist is applied as a substrate (sensitive substrate or photosensitive body) via a projection optical system PL. Both sides of the projection optical system PL are telecentric, and its projection magnification β is reducing magnification. As one example, the projection magnification β of the projection optical system PL is 1/4, 1/5 or the like, and an image-side numerical aperture NA is 0.7, and a diameter of field of view is about 27 to 30 mm. The projection optical system PL is a refractive projection optical system, but a catadioptric projection optical system can also be used. The reticle R and the wafer W can be regarded as a first object and a second object, respectively. A Z-axis is parallel to an optical axis AX of the projection optical system PL, an X-axis is parallel to a paper sheet of FIG. 1 in a plane which is perpendicular to the Z-axis, and a Y-axis is perpendicular to the paper sheet of FIG. 1. When the projection exposing apparatus of the embodiment is a scanning exposing type projection exposing apparatus, a direction (Y direction) extending along the Y-axis is a scanning direction of the reticle R and the wafer W at the time of scanning exposing operation, and an illumination region on the reticle R is a thin and long shape in a direction (X direction) extending along the X-axis which is a non-scanning direction.

A reticle R disposed on the side of an object surface of the projection optical system PL is held by a reticle stage RST (mask stage) by vacuum adsorption or the like. In the case of full field exposing type, the reticle stage RST finely moves in rotation directions around the X direction, the Y direction and the Z-axis on the reticle base (not shown) to position the reticle R. In the case of the scanning exposing type, the reticle stage RST (stage) moves at constant speed at least in the Y direction (scanning direction) on the reticle base (not shown) via an air bearing. A moving coordinate position of the reticle stage RST (positions in the X direction and Y direction, and rotation angle around the Z-axis) is measured in succession by a moving mirror Mr fixed to the reticle stage RST, a reference mirror (not shown) fixed to an upper side surface of the projection optical system PL, and a laser interferometer system 10 opposed to the moving mirror Mr and the reference mirror. In the reality, the laser interferometer system 10 constitutes a three-axes laser interferometer, i.e., one axis in the X direction and two axes in the Y direction.

The reticle stage RST is moved by a drive system 11 comprising a linear motor and a fine motion actuator. Measurement information of the laser interferometer system 10 is supplied to a stage control unit 14, and the stage control unit 14 controls operation of the drive system 11 based on the measurement information and based on control information (input information) from a main control system 20 comprising a computer which controls the operation of the entire device in a centralized manner.

A wafer W disposed on the side of an image surface of the projection optical system PL is held on the wafer stage WST (movable stage) by vacuum adsorption or the like via a wafer holder (not shown). The wafer stage WST includes a wafer table (details thereof will be described later) which adsorbs and holds the wafer W, and a Z leveling mechanism (details thereof will be described later) for controlling a focus position (position in the Z direction) of the wafer W and an inclination angle around the X-axis and Y-axis. The wafer stage WST is disposed on a guide surface (not shown) via an air bearing such that the wafer stage WST can move in the X direction and Y direction. The wafer stage WST is connected to a slider (not shown) via a fine motion mechanism. The slider is driven in the X direction and Y direction along a guide member (not shown) .

In the case of the full field exposing type, the wafer stage WST moves in a stepwise manner on the guide surface in the X direction and Y direction. In the case of the scanning exposing type, the wafer stage WST is placed on the guide surface such that the wafer stage WST can move at constant speed at least in the Y direction at the time of scanning and exposing operation and can move in the X direction and Y direction in the stepwise manner. A moving coordinate position (positions in the X direction and Y direction, and rotation angle around the Z-axis) is measured in succession by a reference mirror Mf fixed to a lower portion of the projection optical system PL, a moving mirror Mw fixed to the wafer stage WST, and a laser interferometer system 12 opposed to the moving mirror Mw. In the reality, the the moving mirror Mw, the reference mirror Mf and the laser interferometer system 12 constitute a three-axes laser interferometer, i.e., at least two axes in the X direction and one axis in the Y direction. In the reality, the laser interferometer system 12 further includes a two-axes laser interferometer for measuring a rotation angle around the X-axis and the Y-axis.

In FIG. 1, the wafer stage WST is moved by a drive system 13 comprising an actuator such as a linear motor and a voice coil motor (VCM). Measurement information of the laser interferometer system 12 is supplied to the stage control unit 14, and the stage control unit 14 controls operation of the drive system 13 based on the measurement information and control information (input information) from the main control system 20.

Diagonal incident type multi-point auto-focus sensors (23A and 23B) are fixed to a lower side surface of the projection optical system PL. The auto-focus sensors 23A and 23B include a projection optical system 23A which projects a slit image on a plurality of measuring points on a surface of the wafer W, and a photoreceiving optical system 23B which receives light reflected from a surface of the projection optical system 23A, which detects information of a lateral deviation amount of a slit image which is again formed, and which supplies the same to the stage control unit 14. The stage control unit 14 calculates a defocus amount from the image surface of the projection optical system PL at the plurality of measuring points using the information of the lateral deviation amount of the slit image, and drives the Z leveling mechanism in the wafer stage WST in an automatic focus method such that the defocus amount falls in the predetermined control precision a the time of exposing operation. Detailed structure of the diagonal incident type multi-point auto-focus sensor is disclosed in Japanese Patent Application Publication Laid-open No.H1-253603 for example.

The stage control unit 14 includes a control circuit on the side of a reticle which controls the drive system 11 optimally based on the measurement information by the laser interferometer 10. The stage control unit 14 also includes a control circuit on the side of a wafer which controls the drive system 13 optimally based on the measurement information by the laser interferometer 12. When the projection exposing apparatus of the embodiment is of the scanning exposing type, if the reticle R and wafer W are scanned in synchronism with each other at the time of scanning and exposing operation, both the control circuits controls the drive systems 11 and 13 in a coordination manner. The main control system 20 exchange commands and parameters between the main control system 20 and various control circuits in the stage control unit 14, and executes the optimal exposing processing in accordance with a program designated by an operator. For this purpose, there is provided an operation panel unit (including an input device and a display device) (not shown) forming an interface between an operator and the main control system 20.

When the exposing operation is carried out, it is necessary to previously align a reticle R and a wafer W with each other. The projection exposing apparatus shown in FIG. 1 is provided with a reticle alignment system (RA system) 21 for setting a reticle R to a predetermined position, and an off-axis type alignment system 22 for detecting a mark on a wafer W.
When the laser light source 1 is an excimer laser light source, a laser control unit 25 which is controlled by the main control system 20 is provided. The laser control unit 25 controls pulse oscillation modes of the laser light source 1 (one pulse mode, burst mode, standby mode and the like). The laser control unit 25 also controls discharging high voltage of the laser light source 1 for adjusting the average light quantity of emitted pulse laser light. A light quantity control unit 27 controls the variable beam attenuator 4 such that the optimal exposure quantity can be obtained based on a signal from a photoelectric detector 26 (integrator sensor) which photo-receives a portion of illumination light divided by the beam splitter 3. The light quantity control unit 27 sends information of intensity (light quantity) of pulse illumination light to the laser control unit 25 and the main control system 20.

In FIG. 1, in the case of the full field exposing type, operation for projecting the pattern of the reticle R on one shot region on the wafer W via the projection optical system PL under the illumination light IL, and operation for moving the wafer W in the X direction and Y direction via the wafer stage WST are repeated in a step and repeat method. On the other hand, in the case of the scanning exposing type, the irradiation of reticle R with illumination light IL is started and an image of a portion of a pattern of a reticle R obtained via the projection optical system PL is projected on one shot region on a wafer W. In this state, the reticle stage RST and the wafer stage WST are moved in synchronization with each other (synchronized scanning) in the Y-direction at a speed ratio of projection magnification of the projection optical system PL. This movement is called scanning exposing action. With this scanning exposing action, the pattern image of the reticle R is transferred on the shot region. Then, the irradiation of illumination light IL is stopped, and the stepping and moving action of a wafer W via the wafer stage WST in the X-direction and Y-direction and the scanning exposing action are repeated. With this, the pattern image of the reticle R is transferred on all of the shot regions on the wafer W by the step and scan method.

Next, structure and operation of the wafer stage WST of the projection exposing apparatus and the wafer stage system including the driving mechanism of the wafer stage WST of the embodiment will be explained. A case in which the projection exposing apparatus of the embodiment is of the full filed exposing type will be explained below, but this can also be applied to a scanning exposing type projection exposing apparatus of course.

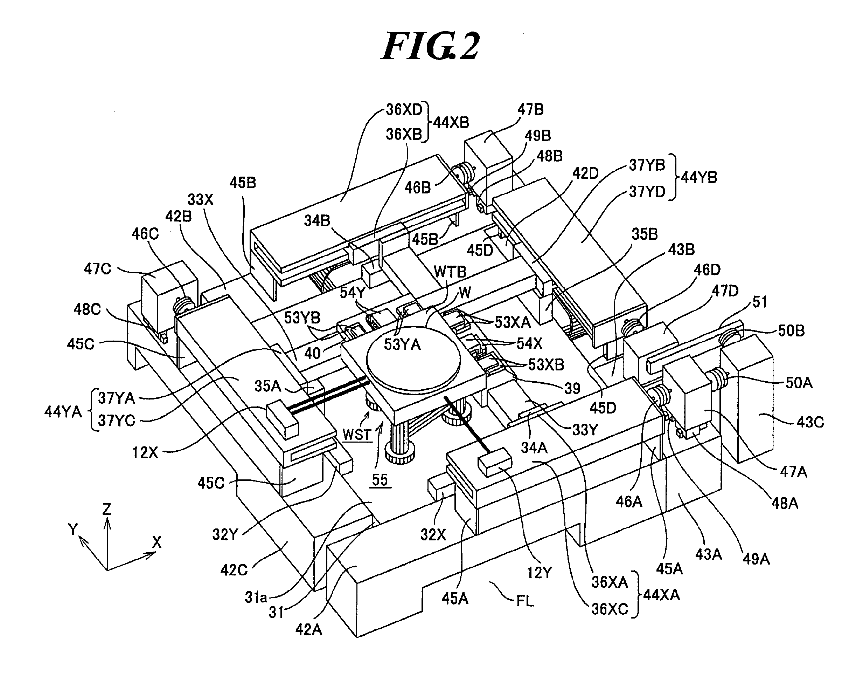

FIG. 2 shows the wafer stage system of the projection exposing apparatus of the embodiment. In FIG. 2, a flat plate-like wafer base 31 (base member) is disposed on a floor FL (disposing surface) in a clean room of a semiconductor device manufacturing factory via a vibration isolation device (not shown). The vibration isolation device (not shown) may be omitted. An upper surface of the wafer base 31 is a guide surface 31a which is finished into a high flatness level, the guide surface 31a is vertical with respect to the Z-axis, and is substantially in parallel to the horizontal plane. A pair of thin and long base members 42A and 42B and a pair of thin and long base members 42C and 42D are disposed on the floor FL such as to sandwich the wafer base 31 in the yd and X direction. A base member 43A is disposed in the vicinity of an intersection between the base member 42A and base member 42D. A prism frame member 43C (frame) is immovably fixed to the floor FL in the + X direction with respect to the base member 43A. The frame member 43C receives reaction force when the stage is driven. In the embodiment, the base members 42A to 42D are independent from the wafer base 31, and the wafer base 31 having the guide surface 31a having the high flatness is set to a minimum size. Therefore, the manufacturing cost can be reduced. It is also possible to integrally form the base member 42A to 42D and the wafer base 31 together.

The wafer stage WST is disposed on the guide surface 31a such that the wafer stage WST can move in the X direction and Y direction via the air bearing. The wafer stage WST includes a wafer table WTB which adsorbs and holds a wafer W (object) via a wafer holder (not shown), and the Z leveling mechanism 55 which controls the position of the wafer table WTB (and wafer) in the Z direction and the inclination angle around the X-axis and Y-axis. The Y-axis guide 33Y (first guide member) which is in parallel to the Y-axis is disposed above the guide surface 31a such that the Y-axis guide 33Y can move in the X direction. An X-axis guide 33X (second guide member) is disposed above the Y-axis guide 33Y substantially in parallel to the X-axis such that the X-axis guide 33X can move in the Y direction. The Y-axis guide 33Y and the X-axis guide 33X intersect with each other substantially at right angles. The cylinder Y-axis slider 39 (first slider) is mounted on an outer surface of the Y-axis guide 33Y such that the cylinder Y-axis slider 39 can move in the Y direction. The cylinder X-axis slider 40 (second slider) is mounted on an outer surface of the Y-axis guide 33Y such that the cylinder X-axis slider 40 can move in the X direction. Inner surfaces of the sliders 39 and 40 are in contact with outer surfaces of the guides 33Y and 33X via air bearings (gas layers such as air). With this, the sliders 39 and 40 can smoothly move along the guides 33Y and 33X. The Z leveling mechanism 55 is connected to the sliders 39 and 40, and the wafer table WTB is disposed on the Z leveling mechanism 55 in a state in which the relative positional relationship between the sliders 39 and 40 can be controlled (details thereof will be described later).

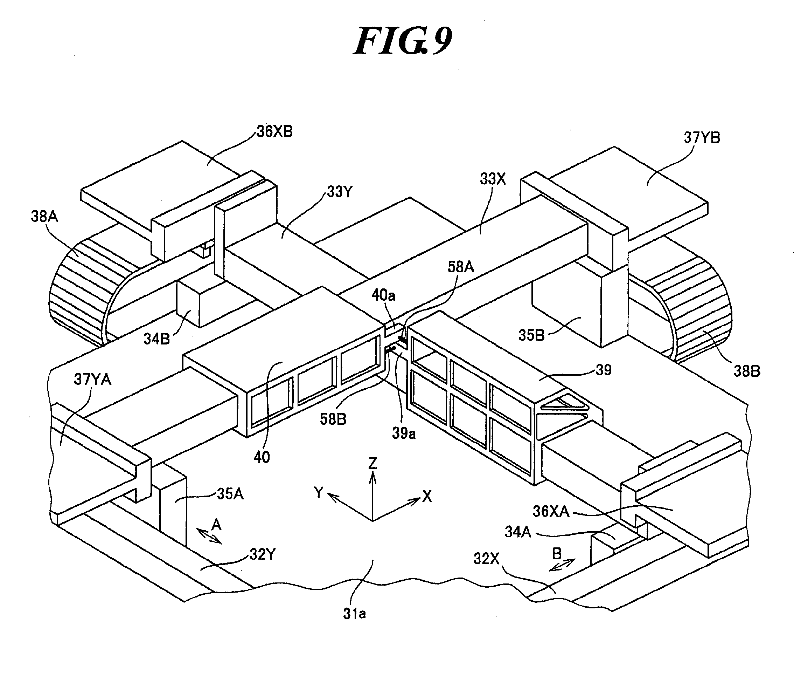

FIG. 9 is an enlarged perspective view showing a support mechanism of the guides 33Y and 33X shown in FIG. 2. In FIG. 9, the X-axis straight guide 32X having a guide surface which is in parallel to an XZ-plane (plane which is in parallel to the X-axis and Z-axis) is fixed to an end of the guide surface 31a in the - Y direction. The Y-axis straight guide 32Y having a guide surface which is in parallel to a YZ-plane (plane which is in parallel to the Y-axis and Z-axis) is fixed to an end of the guide surface 31a in the - X direction. Air pad units 34A and 35A respectively constituting vacuum previously pressing type air bearings are disposed on the guide surface 31a such that the air pad units 34A and 35A can move along the guide surfaces of the X-axis straight guide 32X and the Y-axis straight guide 32Y. The air pad units 34B and 35B constituting vacuum previously pressing type air bearings are disposed on the other end of the guide surface 31a which is separated away from the air pad units 34A and 35A in the Y direction and X direction. Upper surfaces of the air pad units 34A and 34B are connected to each other via the Y-axis guide 33Y, and the air pad units 35A and 35B are connected to each other via the X-axis guide 33X.

In this case, the air pad units 34A, 34B, 35A and 35B are disposed on the guide surface 31A via gas layers of about some µm, and the air pad units 34A and 35A are in contact with the guide surfaces of the straight guides 32X and 32Y via gas layers of about some µm. The air bearings formed between the air pad units 34A and 35A and the straight guides 32X and 32Y are also vacuum previously pressing type air bearings having predetermined adsorbing force. The air pad units 34A and 35A move in the X direction shown with arrow B and in the Y direction shown with arrow A along the straight guides 32X and 32Y, respectively. As a result, the Y-axis guide 33Y connected to the air pad unit 34A and the X-axis guide 33X connected to the air pad unit 35A smoothly move in the X direction and Y direction along the straight guides 32X and 32Y, respectively. Movable elements 36XA and 36XB having coils are fixed to both ends of the Y-axis guide 33Y. Movable elements 37YA and 37YB having coils are fixed to both ends of the X-axis guide 33X. Flexible wirings 38A and 38B for supplying current to these coils are mounted on bottom surfaces of the movable elements 36XB and 37YB.

Referring back to FIG. 2, stators 36XC and 36XD having U-shaped cross section are disposed such as to sandwich the movable elements 36XA and 36XB of the Y-axis guide 33Y from outer sides in a non-contact manner. The stators 36XC and 36XD extends in the X direction. The stators 36XC and 36XD are supported on the base members 42A and 42B so that the stators 36XC and 36XD can displace in the X direction within a predetermined width via a pair of leaf springs 45A and 45B (resilient members having resilience) which are separated away from each other in the X direction. A plurality of magnets are disposed on inner surfaces of the stators 36XC and 36XD at predetermined pitches from one another in the X direction. Similarly, stators 37YC and 37YD having U-shaped cross section are disposed such as to sandwich the movable elements 37YA and 37YB of the X-axis guide 33X from outer sides in a non-contact manner. The stators 37YC and 37YD are supported on the base members 42C and 42D so that the stators 37YC and 37YD can displace in the Y direction within a predetermined width via a pair of leaf springs 45C and 45D (resilient members having resilience) which are separated away from each other in the Y direction. A plurality of magnets are disposed on inner surfaces of the stators 37YC and 37YD at predetermined pitches from one another in the Y direction. The movable elements 36XA and 36XB and the stators 36XC and 36XD constitute a pair of linear motors 44XA and 44XB in the X-axis as coarse motion mechanisms (or drive mechanisms) for driving the Y-axis guide 33Y in the X direction with respect to the guide surface 31a. The movable elements 37A and 37YB and the stators 37YC and 37YD constitute the pair of linear motors 44YA and 44YB of the Y-axis as the coarse motion mechanisms (or drive mechanisms) for driving the X-axis guide 33X in the Y direction with respect to the guide surface 31a.

As described above, the stators 36XC and 36XD of the embodiment are supported on the base members 42A and 42B via the leaf springs 45A and 45B, and the stators 37YC and 37YD are supported on the base members 42C and 42D via the leaf springs 45C and 45D. When the Y-axis guide 33Y is driven in the X direction by the linear motors 44XA and 44XB, the stators 36XC and 36XD receive the reaction force thereof and displace in the opposite direction. Similarly, when the X-axis guide 33X is driven in the Y direction by the linear motors 44YA and 44YB, the stators 37YC and 37YD receive the reaction force thereof and displace in the opposite direction. Therefore, since the stators 36XC and 36XD, and 37YC and 37YD are supported in the simple counter balance method, vibration caused when the linear motors 44XA, 44XB, 44YA and 44YB as the coarse motion mechanisms are driven can be reduced.

Since the leaf springs 45A to 45D have resilience, when the guide 33Y or 33X stops, the stators 36XC and 36XD or stators 37YC and 37YD return to their neutral positions. Therefore, it is unnecessary to newly provide a drive mechanism for adjusting positions of the stators 36XC, 36XD, 37YC and 37YD. The linear motors 44XA, 44XB, 44YA and 44YB of the embodiment are of a moving coil type, and the movable elements 36Xa and 37YA fixed to the guides 33Y and 33X can be reduced in weight. The linear motors 44XA, 44XB, 44YA and 44YB can be of a moving magnet type.

In the embodiment, there is a mechanism which further reduces vibration of the stators 36XC, 36XD, 37YC and 37YD, and to reduce the influence of the vibration caused by the driving reaction forces of the linear motors 44XA, 44XB, 44YA and 44YB. This mechanism will be described later.
In FIG. 9, if the linear motors 44XA, 44XB, 44YA and 44YB shown in FIG. 2 are driven, the Y-axis guide 33Y and the X-axis guide 33X smoothly move in the X direction and Y direction along the straight guides 32X and 32Y, respectively. At that time, the Y-axis slider 39 and the X-axis slider 40 integrally move in the X direction and Y direction in association with the Y-axis guide 33Y and the X-axis guide 33X. The sliders 39 and 40 are made of metal such as steel, brass, aluminum or the like and have rigid structures. A projection 39a of an end of the Y-axis slider 39 in the + Y direction and a projection 40a of an end of the X-axis slider 40 in the + X direction are connected to each other via the rod 58A (connecting member) extending in the Y direction and the rod 58B (connecting member) extending in the X direction as flexible structures.

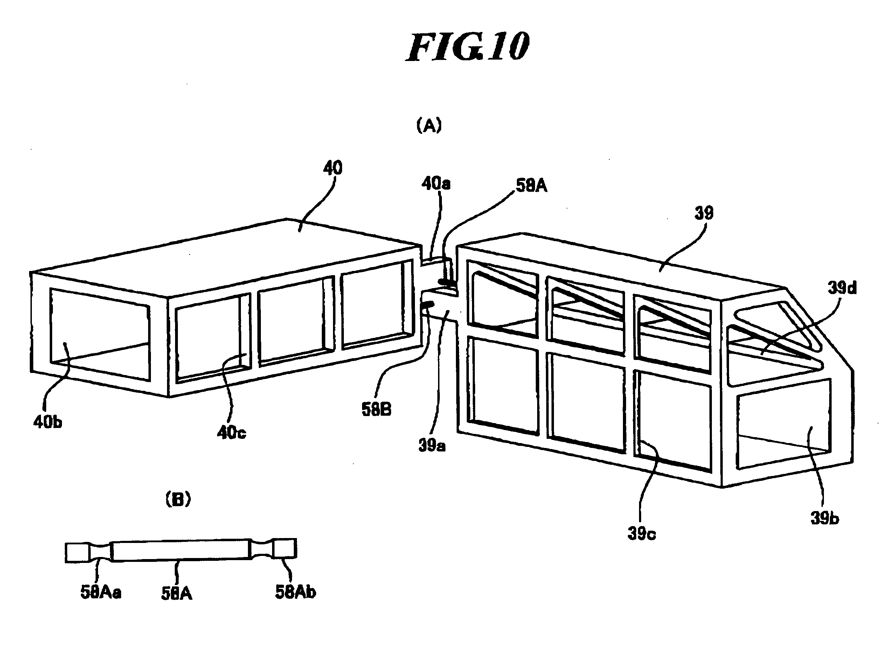

As shown in FIG. 10(B), the rod 58A (also the rod 58B) is provided at its both ends with flexure mechanisms 58Aa and 58Ab which are easily deformed. The rod 58A is not deformed in its longitudinal direction almost at all, but the rod 58A can resiliently deform to a certain extent in a direction perpendicular to the longitudinal direction. In FIG. 9, the two rods 58A and 58B connect the projections 39a and 40a such that the projections 39a and 40a are substantially in parallel to the Y-axis and Z-axis. Therefore, the Y-axis slider 39 and the X-axis slider 40 are connected to each other such that the relative positional relationship therebetween in the X direction and Y direction is not varied via the two rods 58A and 58B and such that the relative rotation angle around the X-axis, Y-axis and Z-axis can be permitted to a certain extent.

Therefore, if the Y-axis guide 33Y is driven in the X direction, the X-axis slider 40 is driven in the X direction along the X-axis guide 33X in association with the Y-axis slider 39, and if the X-axis guide 33X is driven in the Y direction, the Y-axis slider 39 is driven in the Y direction along the Y-axis guide 33Y in association with the X-axis slider 40. Since the inner surfaces of the sliders 39 and 40 are respectively provided with air bearings, the sliders 39 and 40 can smoothly move. Since the Y-axis slider 39 and X-axis slider 40 are connected to each other via the rods 58A and 58B, the mechanical interference between the sliders 39 and 40 can be reduced. In other words, vibration and thermal variation transmitted from the linear motors 44XA and 44XB shown in FIG. 2 to the Y-axis slider 39 via the Y-axis guide 33Y are attenuated by the rods 58A and 58B and transmitted to the X-axis slider 40, and vibration and thermal variation transmitted from the linear motors 44YA and 44YB shown in FIG. 2 to the X-axis slider 40 via the X-axis guide 33X are attenuated by the rods 58A and 58B and transmitted to the Y-axis slider 39. Therefore, as compared with a case in which the sliders 39 and 40 are integrally formed together, the sliders 39 and 40 can be reduced in size and weight, and vibration and thermal variation caused when the sliders 39 and 40 are driven in the X direction and Y direction in association with each other can be reduced.

FIG. 10(A) is an enlarged perspective view showing the sliders 39 and 40 shown in FIG. 9. In FIG. 10(A), the sliders 39 and 40 have skeleton structures so as to reduce their weights. That is, the sliders 39 and 40 are provided with openings 39b and 40b via which the guides 33Y and 33X shown in FIG. 9 are inserted. The sliders 39 and 40 are also provided at their side surfaces with a plurality of recesses 39c and 40c. The Y-axis slider 39 is formed thicker than the X-axis slider 40 and therefore, a reinforcing rod 39d is disposed in the Y-axis slider 39. By reducing the sliders 39 and 40 in weight in this manner, the sliders 39 and 40 can be driven at higher speed without increasing the size of the coarse motion mechanism which drives the sliders 39 and 40.

Referring back to FIG. 2, the Z leveling mechanism 55 is connected to the sliders 39 and 40, and the wafer table WTB is disposed on the Z leveling mechanism 55 via the air bearing (e. g. , vacuum pressure air bearing). The wafer table WTB and the Y-axis slider 39 are connected to each other via the actuators 53XA and 53XB of the X-axis comprising voice coil motors and the EI core type actuator 54X of the X-axis in a state in which the relative position can be controlled in a non-contact manner. The wafer table WTB and the X-axis slider 40 are connected to each other via the actuators 53YA and 53YB of the Y-axis comprising voice coil motors and the EI core type actuators 53YA and 53YB of the Y-axis in a state in which the relative position can be controlled in a non-contact manner.

In this case, the average position of the wafer table WTB in the X direction and Y direction with respect to the sliders 39 and 40 is controlled by the actuators 54X and 54Y. The position of the wafer table WTB in the X direction and the rotation angle around the Z-axis are finely adjusted by the average value and balance of thrusts of the actuators 53XA and 53XB in the X direction, and the position of the wafer table WTB in the Y direction is finely adjusted by the average value of thrusts of the actuators 53YA and 53YB in the Y direction. That is, the actuators 53XA, 54X, 53XB, 53YA, 54Y and 53YB can be regarded as fine motion mechanisms which relatively drive the wafer table WTB (wafer W) in a predetermined narrow range in the X direction and the Y direction and in the rotation direction around the Z-axis with respect to the sliders 39 and 40.

In FIG. 2, a mirror-finished surface of the wafer table WTB in the - X direction is irradiated with two laser beams which are separated away from the laser interferometer 12X in the Y direction, and a mirror-finished surface of the wafer table WTB in the - Y direction is irradiated with laser beam from the laser interferometer 12Y. Coordinates of the wafer table WTB (wafer W) in the X direction and Y direction and the rotation angle around the Z-axis are measured by the laser interferometers 12X and 12Y. The linear motors 44XA, 44XB, 44YA and 44YB (coarse motion mechanism) and the actuators 53XA, 54X, 53XB, 53YA, 54Y and 53YB (fine motion mechanism) correspond to the drive system 13 in FIG. 1.

The stage control unit 14 shown in FIG. 1 drives the coarse motion mechanism and the fine motion mechanism based on the measurement information of the laser interferometers 12X and 12Y. The coarse motion mechanism can be used for moving the wafer table WTB in the stepwise manner in the case of the full field exposing type and scanning exposing type, and the coarse motion mechanism can also be used for moving the wafer table WTB at constant speed at the type of synchronous scanning operation in the case of the scanning exposing type. The fine motion mechanism can be used for correcting a positioning error of the wafer table WTB in the case of the full field exposing type and scanning exposing type, and the fine motion mechanism can also be used for correcting the synchronous error of the wafer table WTB at the time of scanning and exposing operation.

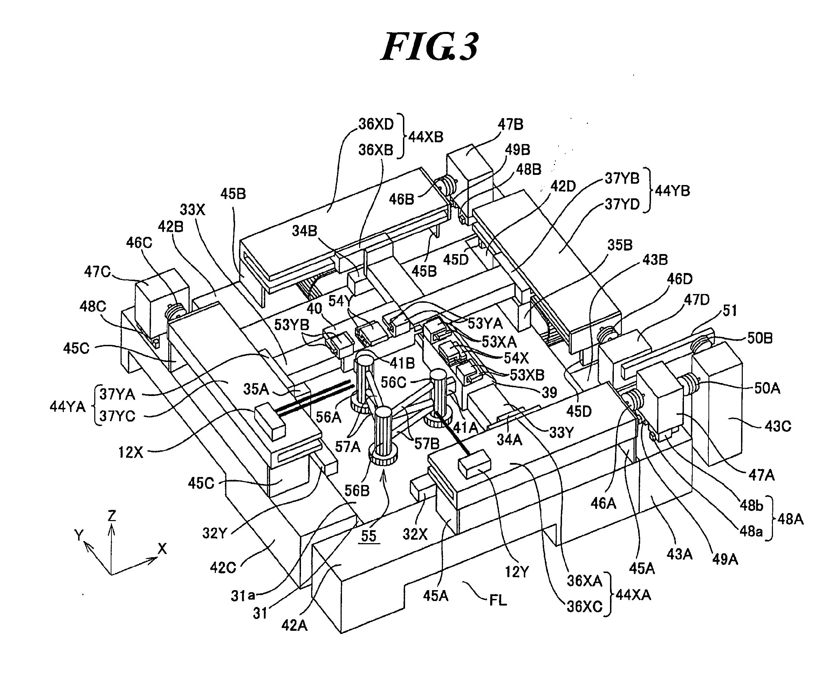

FIG. 3 shows a state of FIG. 2 from which the wafer table WTB is removed. In FIG. 3, the Z leveling mechanism 55 includes substrate columnar Z-axis actuators 56A, 56B and 56C which are disposed in the vicinity of three apexes of a substantially regular triangle and which can control three heights in the Z direction, a pipe unit 57A (connecting mechanism) comprising three hollow pipes which connect the Z-axis actuators 56A and 56B, and a pipe unit 57B (connecting mechanism) comprising three hollow pipes which connect the Z-axis actuators 56B and 56C. The pipe units 57A and 57B are made of material having relatively small rigidity such as aluminum and glass fiber.

In this case, the Z-axis actuators 56A to 56C correspond to drive members which drive the wafer table WTB to a position where the wafer table WTB intersects with the guide surface 31a. As one example, each of the Z-axis actuators 56A to 56C includes a steel base member, a steel movable member which is supported by a diaphragm with respect to this base member and which can displace in the Z direction, and a voice coil motor which drives this movable member in the Z direction. Air pads for constituting vacuum previously pressing type air bearings are incorporated in upper and lower portions of the Z-axis actuators 56A to 56C. In the Z leveling mechanism 55, the two Z-axis actuators 56C and 56A are connected to the Y-axis slider 39 and the X-axis slider 40 via the flat plate-like flexures 41A and 41B, respectively. The flat plate-like flexures 41A and 41B correspond to connecting members of flexible structures which connect the wafer stage WST (movable stage) to the sliders 39 and 40 (sliders).

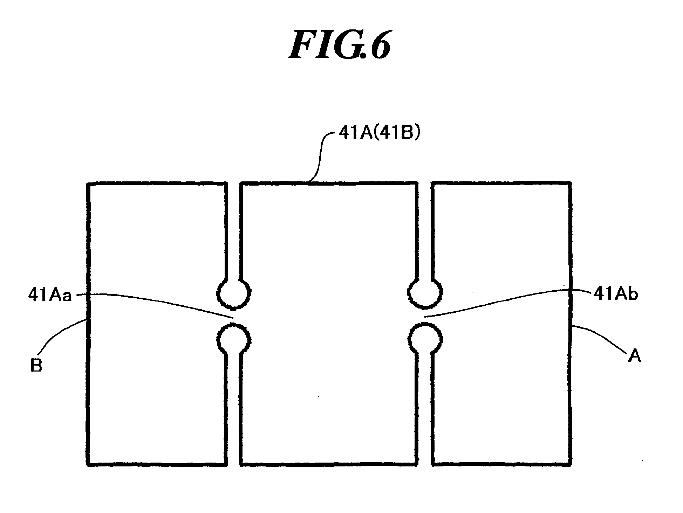

FIG. 6 is an enlarged view showing the flat plate-like flexure 41A (which is the same as 41B). In FIG. 6, the flat plate-like flexure 41A is provided with pivot portions 41Aa and 41Ab which can easily displaced by slotting at two locations between end surfaces A and B connected by two members. Therefore, the flat plate-like flexure 41A can not easily displace in a direction which is in parallel to a straight line (straight line connecting the end surfaces A and B) connecting the two members, but can displace in a direction perpendicular to the straight line to some extent. For this purpose, a member which is the same as the rod 58A having the flexure mechanism shown in FIG. 10 (B) can be used instead of the flat plate-like flexures 41A and 41B. In a structure which connects the Z leveling mechanism 55 to the sliders 39 and 40 by means of the two flat plate-like flexures 41A and 41B, it is possible to easily incorporate the Z leveling mechanism 55.

In the Z leveling mechanism 55 shown in FIG. 3, the pipe units 57A and 57B are structures (members having relatively flexible structures) having rigidities smaller than those of the Z-axis actuators 56A to 56C. The Z-axis actuators 56C and 56A connected to the sliders 39 and 40 via the flat plate-like flexures 41A and 41B are not connected to each other. Thus, since the Z-axis actuators 56C and 56A can relatively displace within a fine range to some extent, there is a merit that almost no deformation stress is applied between the Y-axis slider 39 and the X-axis slider 40 and between the three Z-axis actuators 56A to 56C when the Z leveling mechanism 55 (wafer stage WST) is driven in the X direction and Y direction on the guide surface 31a via the Y-axis guide 33Y and the X-axis guide 33X.

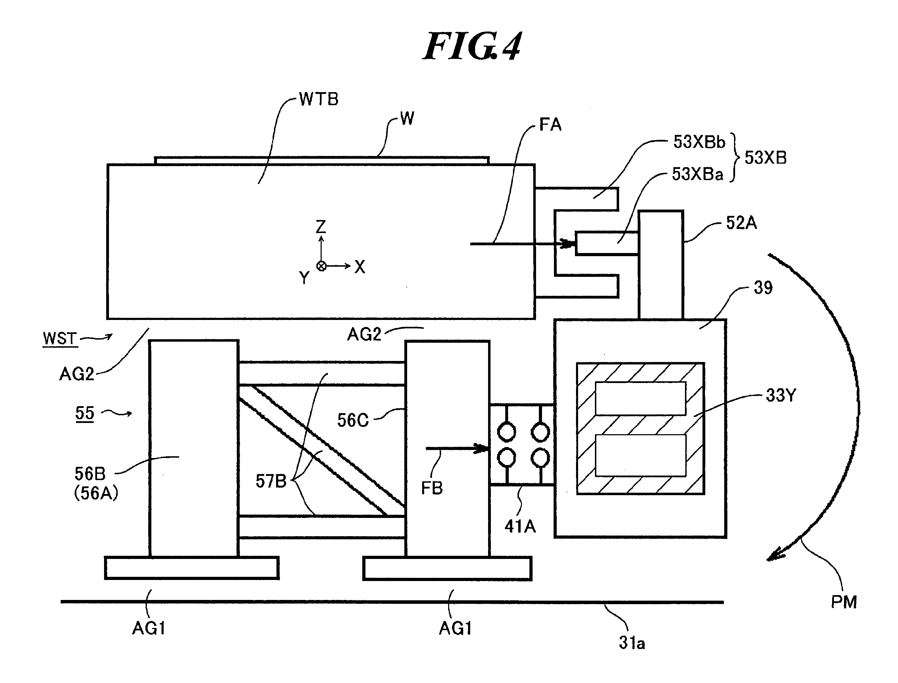

Next, the positional relationship between the Z leveling mechanism 55 and the wafer table WTB will be explained with reference to FIG. 4.
FIG. 4 is a side view of the wafer stage WST shown in FIG. 2. In FIG. 4, vacuum previously pressing type air pads (gas bearing mechanisms) are incorporated in both ends of the Z-axis actuators 56A to 56C constituting the Z leveling mechanism 55. High pressure gas (e.g., air) is supplied to the Z-axis actuators 56A to 56C through flexible supply pipes (not shown), and gas sucked from portions of the both ends of the Z-axis actuators 56A to 56C is discharged through discharge pipes (not shown). As a result, the Z-axis actuators 56A to 56C are disposed on the guide surface 31a via a gas layer AG1 of about 1µm, and is stably disposed on the Z-axis actuators 56A to 56C via a gas layer AG2 whose thickness is maintained at about some µm.

In the embodiment, the heights of the three Z-axis actuators 56A to 56C in the Z direction can be controlled independently from one another. At the time of exposing operation, the heights of the three Z-axis actuators 56A to 56C are controlled continuously based on the measurement information of the multi-point auto-focus sensors (23A and 23B) shown in FIG. 1, and the height of the wafer table WTB (wafer W) in the Z direction and the inclination angle around the X-axis and Y direction are controlled. With this, the surface (exposing surface) of the wafer W can match with an image surface of the projection optical system PL shown in FIG. 1.

When vibration from the floor FL is transmitted to the wafer table WTB via the wafer base 31, the three Z-axis actuators 56A to 56C may be controlled such as to offset this vibration also. When vibration from the floor FL is offset by the three Z-axis actuators 56A to 56C in this manner, the vibration isolation device (not shown) which supports (vibration isolates) the wafer base 31 can be omitted.

Next, the actuators 53XA, 54X, 53XB, 53YA, 54Y and 53YB as the fine motion mechanisms for the wafer table WTB (wafer W) of the wafer stage WST shown in FIG. 2 will be explained in detail. In this case, the actuators 54XA and 54XB of the voice coil motor type X-axis have the same structures. The actuators 53YA, 54Y and 53YB provided between the X-axis slider 40 and the wafer table WTB correspond to structures of the actuators 53YA, 54Y and 53YB provided between the Y-axis slider 39 and the wafer table WTB which are rotated around the axis parallel to the Z-axis.

As shown in FIG. 4, the voice coil motor type actuator 53XB includes a stator 53XBa which is fixed to a projection 52A fixed to the Y-axis slider 39 and which includes a coil, and a movable element 53XBb which is fixed to a side surface of the wafer table WTB and which includes a permanent magnet for generating magnetic field in the Z direction. Thrust which drives the wafer table WTB in the X direction with respect to the Y-axis slider 39 is generated by the actuator 53XB. When the Y-axis guide 33Y is driven in the - X direction and the wafer stage WST is driven in the - X direction, thrust in the - X direction is applied to the wafer table WTB by the actuator 53XB. Therefore, a reaction force in the + X direction becomes FA. A reaction force in the + X direction applied to the flat plate-like flexure 41A from the Z leveling mechanism 55 becomes FB. Normally, the reaction force FA and the reaction force FB have different values and thus, a moment PM around the Y-axis is applied to the Y-axis slider 39. In this regard, in this embodiment, the flat plate-like flexure 41A having the flexible structure is used as a connecting member between the Y-axis slider 39 and the Z leveling mechanism 55, and the Z leveling mechanism 55 and the wafer table WTB are sucked to the guide surface 31a and the Z leveling mechanism 55 respectively via predetermined gas layers by the vacuum previously pressing type air bearing. Since the reaction force FB pushes a center of gravity of the Z leveling mechanism 55 which is coupled to the flat plate-like flexure 41A, pitching is not generated in the wafer stage WST, and the wafer stage WST is not displaced by the moment PM.

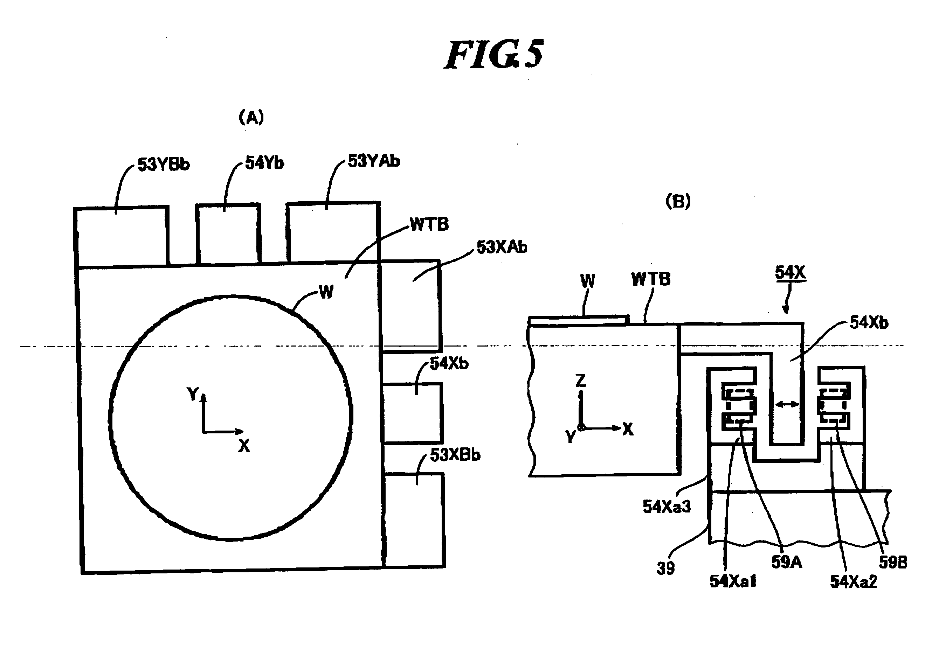

Next, FIG. 5(A) is a plan view showing the wafer table WTB shown in FIG. 2, and FIG. 5(B) is a side view showing a portion of the wafer table WTB and the actuator 54X shown in FIG. 2. As shown in FIG. 5(A), the movable elements 53XAb, 54Xb, 53XBb, 53YAb, 54Yb and 53YBb of the actuators 53XA, 54X, 53XB, 53YA, 54Y and 53YB shown in FIG. 2 are fixed to the wafer table WTB. As shown in FIG. 5(B), the EI core type X-axis actuator 54X includes a non-magnetic connecting section 54Xa3 fixed to the Y-axis slider 39, an E-shaped cores 54Xa1 and 54Xa2 fixed to both ends of the connecting section 54Xa3 in the X direction, coils 59A and 59B wound around a central projections of the E-shaped cores 54Xa1 and 54Xa2, and a movable element 54Xb whose one end is fixed to the wafer table WTB and whose other end is formed into a magnetic I-shaped core. In this case, the tip end (I-shaped core) of the movable element 54Xb is disposed between the E-shaped cores 54Xa1 and 54Xa2. By adjusting balance of current flowing through the coils 59A and 59B of the E-shaped cores 54Xa1 and 54Xa2, the position of the movable element 54Xb in the X direction and the relative position of the wafer table WTB (wafer W) in the X direction with respect to the Y-axis slider 39 can be controlled.

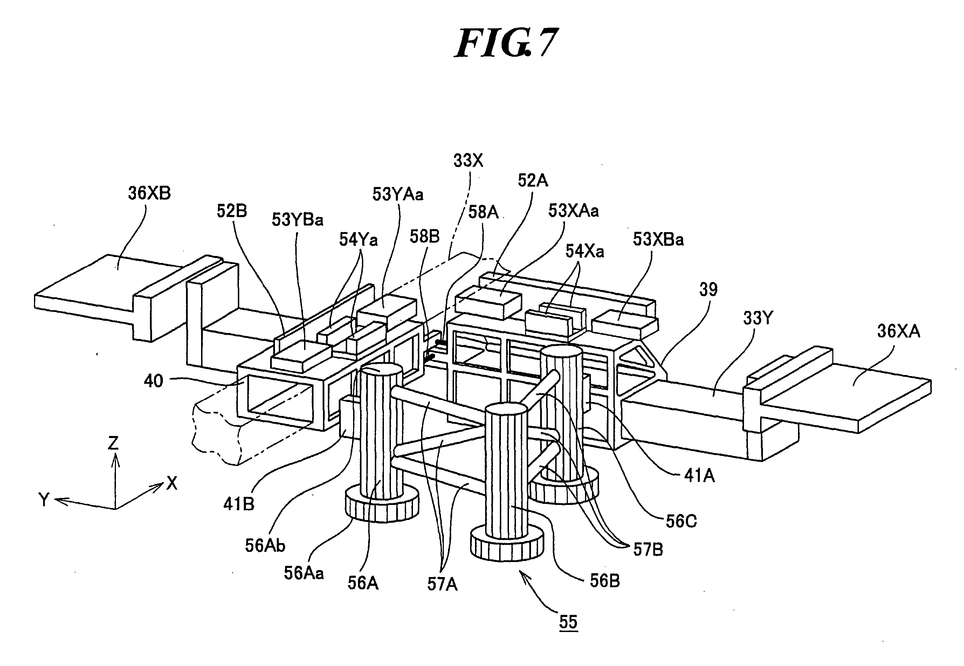

In FIG. 5(B), the Connecting section 54Xa3, the E-shaped cores 54Xa1 and 54Xa2 and the coils 59A and 59B constitute the stator 54Xa (see FIG. 7) of the actuator 54X.
FIG. 7 shows stators of the actuators 53XA, 54X, 53XB, 53YA, 54Y and 53YB shown in FIG. 2 and the Z leveling mechanism 55. In FIG. 7, the stators 53XAa and 53XBa of the actuators 53XA and 53XB of the X-axis are fixed to the projection 52A provided on the Y-axis slider 39, and the stators 53YAa and 53YBa of the actuators 53YA and 53YB of the Y-axis are fixed to the projection 52B provided on the X-axis slider 40. The stator 54Ya of the actuator 54Y of Y-axis having a structure that the stator 54Xa is rotated by 90 degrees is fixed to the X-axis slider 40.

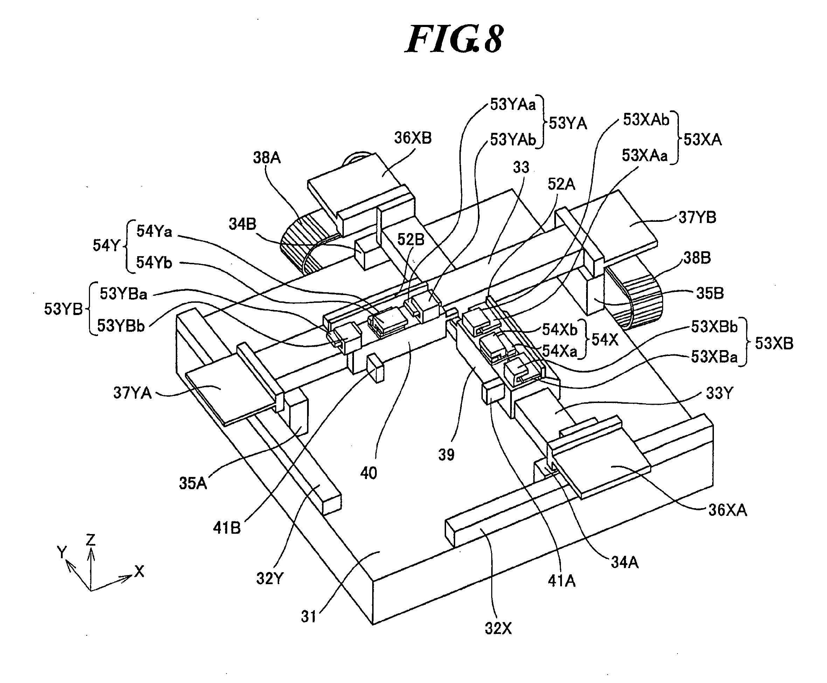

FIG. 8 shows a state of a drive mechanism (coarse motion mechanism) which drives the wafer stage WST and the guides 33Y and 33X from which the mechanism on the side of the stator. In FIG. 8, the stator 53XAa, 54Xa, 53XBa, 53YAa, 54Ya and 53YBa fixed to the sliders 39 and 40, and the movable elements 53XAb, 54Xb, 53XBb, 53YAb, 54Yb and 53YBb fixed to the wafer table WTB shown in FIG. 2 constitute six-axes actuators 53XA, 54X, 53XB, 53YA, 54Y and 53YB which are non-contact fine motion mechanisms.
It is only necessary that the relative position of the wafer table WTB with respect to the sliders 39 and 40 can be corrected by three-degrees of freedom of X direction, Y direction and the rotation direction around the Z-axis. Therefore, it is only necessary that the actuator for the fine motion mechanism has three axes at minimum. For example, the fine motion mechanism can be constituted using only one Y-axis actuator 54Y and two X-axis actuators 54XA and 54XB.

In FIG. 2, as one example, the EI core type X-axis actuator 54X is used for stably maintain the wafer table WTB in a substantially predetermined positional relationship in the X direction in the non-contact manner with respect to the Y-axis slider 39. A position of the wafer table WTB in the X direction with respect to the Y-axis slider 39 and the rotation angle around the Z-axis are finely adjusted at high speed by the two voice coil motor type X-axis actuators 53XA and 53XB on both ends thereof. Similarly, the EI core type Y-axis actuator 54Y is used for stably maintain the wafer table WTB in a substantially predetermined positional relationship in the Y direction in the non-contact manner with respect to the Y-axis slider 40. A position of the wafer table WTB in the Y direction with respect to the X-axis slider 40 is finely adjusted at high speed by the two voice coil motor type Y-axis actuators 53YA and 53YB on both ends thereof.

In FIG. 2, the position of the moving wafer table WTB (wafer W) is precisely measured by the laser interferometers 12X and 12Y in this embodiment. Therefore, it is preferable that the wafer table WTB (table portion) is made of material (e.g., ceramic) which is not easily deformed, and which is light in weight and has high specific rigidity (value obtained by dividing rigidity by weight of unit volume). One example of the material of the wafer table WTB is ceramic. Glass ceramic (ceramic having low expansion coefficient) can be used as the ceramic.

However, since material having high specific rigidity is generally expensive, it is preferable to minimize the amount of such material in such a range that the apparatus performance such as the exposing precision (positioning precision, superposing precision) is not deteriorated. In this embodiment, aluminum is used for the large X-axis guide 33X and Y-axis guide 33Y (guide members) because aluminum has specific rigidity lower than that of the material of the wafer table WTB but is inexpensive. At that time, the guides 33X and 33Y are hollow so as to reduce them in weight.

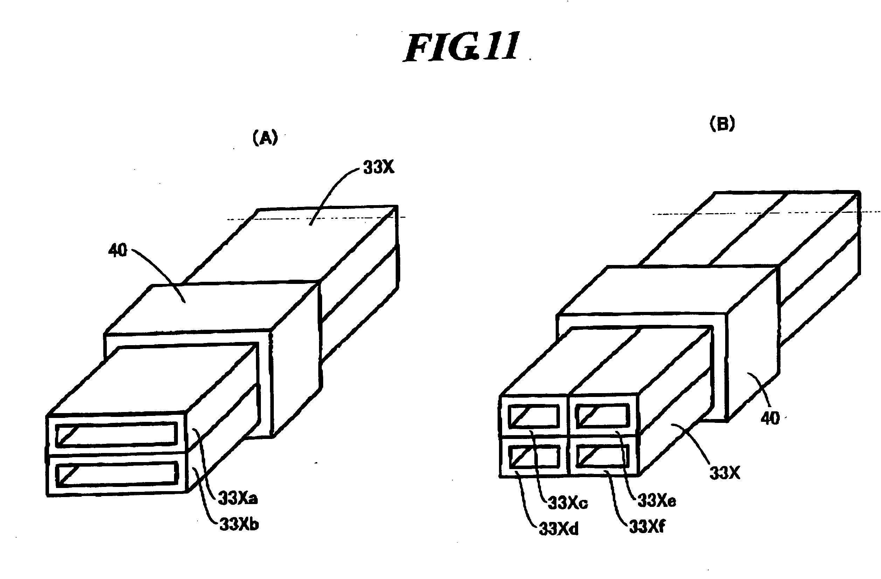

FIG. 11 (A) shows one example of the structure of the X-axis guide 33X. In FIG. 11(A), the X-axis guide 33X on which the X-axis slider 40 is mounted is formed by pasting two hollow cylindrical members 33Xa and 33Xb on each other using epoxy resin-based adhesive. The cylindrical members 33Xa and 33Xb are made of aluminum extrusion material and have thin and long rectangular cross sections. By pasting the two cylindrical members 33Xa and 33Xb on each other, it is easy to manufacture the guide and the members exhibit high rigidity and high attenuation characteristics of vibration although their weights are light.

FIG. 11 (B) shows another example of the X-axis guide 33X. In FIG. 11(B), the X-axis slider 40 is mounted on the X-axis guide 33X. The X-axis guide 33X is formed by pasting four thin and long cylindrical members 33Xc, 33Xd, 33Xe and 33Xf on each other. The four cylindrical members 33Xc to 33Xf are made of aluminum extrusion material and have thin and long rectangular cross sections. By pasting the four cylindrical members 33Xc to 33Xf on each other, the members exhibit higher rigidity and higher attenuation characteristics of vibration.

Next, a mechanism which further reduces vibration of the stators 36XC, 36XD, 37YC and 37YD shown in FIG. 2, and to reduce vibration generated by the linear motors 44XA, 44XB, 44YA and 44YB (coarse motion mechanisms) will be explained.
In FIG. 2, sliders 48A and 49A are disposed on the base member 43A such that the sliders 48A and 49A can move in the X direction along the straight guide at a predetermined distance from each other in the Y direction, and a damper member 47A (mass body) in the X-axis having a predetermined mass is fixed to the sliders 48A and 49A. That is, the damper member 47A is disposed on the base member 43A such that the damper member 47A can smoothly move in the X direction, and mass (M2) of the damper member 47A is set smaller than mass (M1) of the stator 36XC. Upper portions of the stator 36XC, the damper member 47A and the frame member 43C are disposed along a straight line which is substantially in parallel to the X-axis. The stator 36XC and the damper member 47A are connected to each other via a coil spring 46A (first connecting member), and the damper member 47A and the upper portion of the frame member 43C (frame) are connected to each other via a coil spring 50A (second connecting member). Similarly, a damper member 47D (mass body) is disposed on a base member 43B such that the damper member 47D can smoothly move in the Y direction via a slider (not shown), one end of a plate 51 projecting in the + X direction is fixed to a back surface of the damper member 47D, a stator 37YD and the damper member 47D are connected to each other via a coil spring 46D (first connecting member), and the other end of the plate 51 (damper member 47D) and the frame member 43C are connected to each other via a coil spring 50B (second connecting member).

A damper member 47B is disposed on the base member 42B via sliders 48B and 49B in symmetric relation with the damper member 47A. The stator 36XC and the damper member 47B are connected to each other via a coil spring 46B. In this structure, a member which is the same as the frame member 43C may be fixed to a location close to the damper member 47B, and this member may be connected to the damper member 47B via a coil spring. Similarly, a damper member 47C is disposed on a base member 42C via a slider 48C in a symmetric relation with the damper member 47D such that the damper member 47C can move in the Y direction. The stator 37YC and the damper member 47C are connected to each other via a coil spring 46C. At that time, a member which is the same as the frame member 43C may be fixed to a location close to the damper member 47C, and this member may be connected to the damper member 47C via a coil spring. Leaf springs or the like may be used instead of the coil springs 46A to 46D, 50A and 50B.

Here, functions of the damper member 47A and the frame member 43C shown in FIG. 2 will be explained.

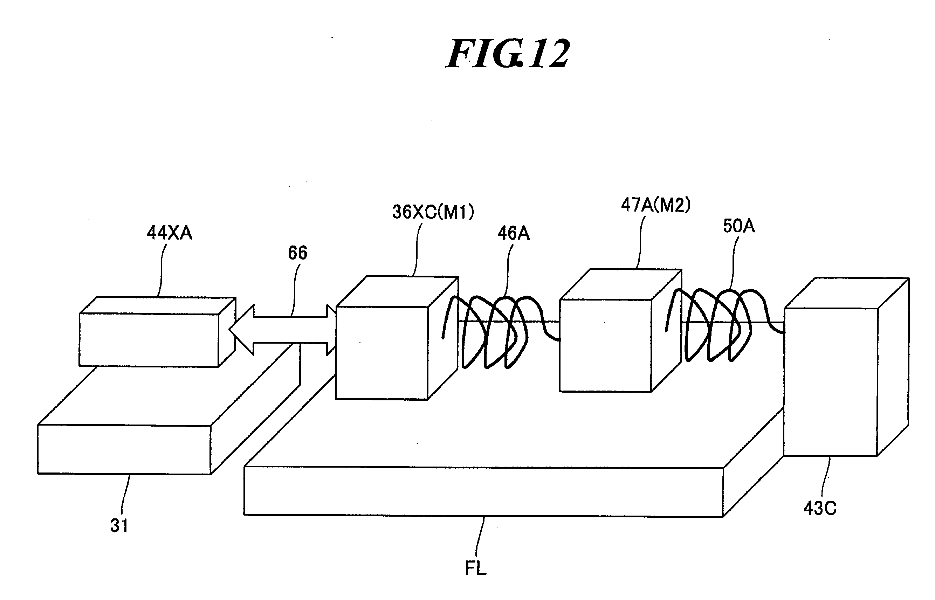

FIG. 12 is a schematic view showing members from the linear motor 44XA to the frame member 43C shown in FIG. 2. In FIG. 12, a stator of the linear motor 44XA on the wafer base 31 is connected to the stator 36XC of mass M1 via a high rigid rod 66 in a phantom manner, the stator 36XC is connected to the damper member 47A of mass M2 is via a coil spring 46A, and the damper member 47A is connected to the frame member 43C fixed to the floor FL via a coil spring 50A. In this case, the stator 36XC and the damper member 47A are movably disposed on the floor FL, and resistances at the time of movement are mainly inertial forces of masses M1 and M2. If the stator 36XC vibrates by the reaction force when the linear motor 44XA is driven, high frequency component of about 50 Hz or higher of the vibration is attenuated by the stator 36XC and the coil spring 46A, and only low frequency component lower than 50 Hz is transmitted to the damper member 47A via the coil spring 46A. High frequency component of the vibration of the damper member 47A is further attenuated by the damper member 47A and the coil spring 50A, and only low frequency component is transmitted to the frame member 43C via the coil spring 50A.

That is, since the stator 36XC and the damper member 47A which are connected in series function as low pass filter, high frequency component of vibration of the stator 36XC is largely attenuated in two stages by the members from the stator 36XC to the coil spring 50A, and only the low frequency component is transmitted to the frame member 43C. In this regard, the stator 36XC and the damper member 47A can be called filtered reaction masses. In this case, since the frame member 43C is fixed to the floor FL having large mass, the frame member 43C as a fixed reaction frame does not move almost at all, and the low frequency vibration is attenuated in the frame member 43C. Therefore, according to the embodiment, influence of vibration caused by the reaction force when the linear motor 44XA is driven by the simple mechanism can be reduced. The same can be applied to a mechanism including the damper member 47D shown in FIG. 2.

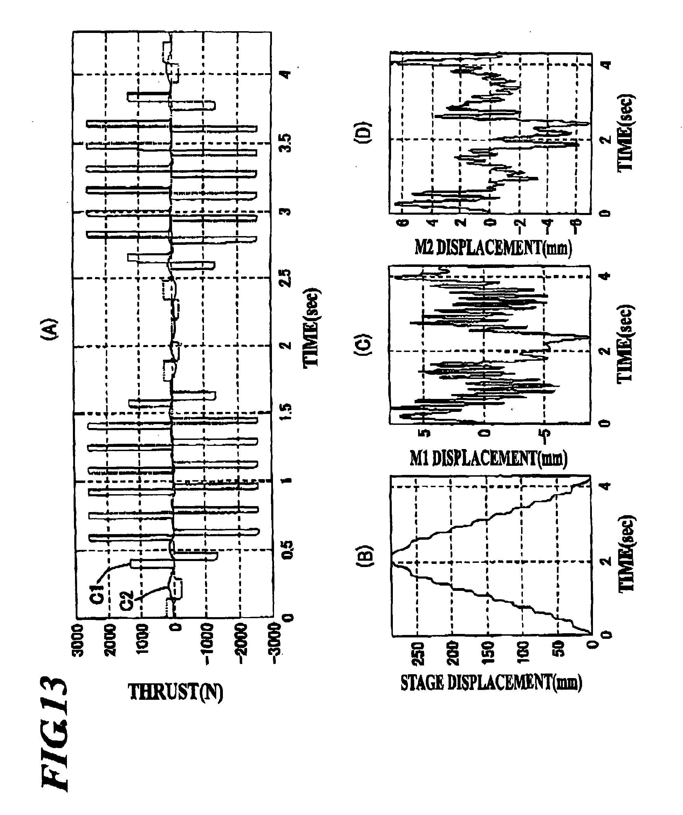

FIG. 13 show one example of a simulation result of a filtered reaction mass type vibration attenuation mechanism shown in FIG. 12, wherein FIG. 13 (A) shows variation, with time, of thrust (N) of the linear motor 44XA of the X-axis shown in FIG. 2, FIG. 13(B) shows stage variation (mm) which is displacement of the Y-axis guide 33Y (wafer stage WST) at that time, FIG. 13(C) shows displacement of the stator 36XC in the X direction at that time ("M1 displacement", hereinafter) (mm), and FIG. 13(D) shows displacement of the damper member 47A in the X direction at that time ("M2 displacement", hereinafter) (mm). Lateral axes in FIGS. 13(A) to 13(D) show time (sec), a regular waveform C1 in FIG. 13 (A) shows theoretic thrust when the stator of the linear motor is stopped, and sine wave waveform C2 shows a difference (leaked thrust) between the theoretic thrust and the actual thrust (thrust in which vibration attenuation mechanism in FIG. 12 is taken into account). The simulation was carried out under conditions that the maximum value of the leaked thrust C2 became about several % of the theoretic thrust C1, and the displacement amount of the stator 36XC became about ±9 mm. In this embodiment, the Y-axis guide 33Y (wafer stage WST) is reciprocated stepwisely in a range of about 285 mm width as shown in FIG. 13(B), the theoretic thrust C1 (FIG. 13(A)) of the linear motor is varied in a square wave at predetermined pitch.

According to this simulation, since the frequency component of the displacement (displacement of M2) of the damper member 47A is lower than the displacement (displacement of M1) of the stator 36XC, it can be found that the stator 36XC and the damper member 47A function as low pass filters, and the vibration is attenuated.
Although the stator 36XC, the damper member 47A and the frame member 43C are disposed in series in FIG. 12, the damper member 47A and the frame member 43C may be disposed in parallel.

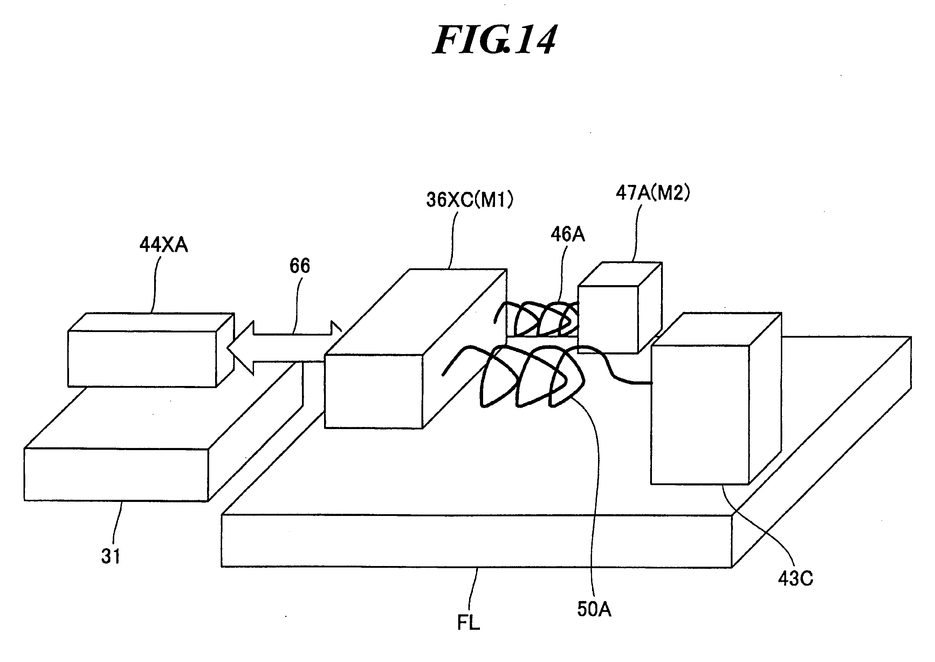

FIG. 14 shows such a filtered reaction mass type vibration attenuation mechanism. In FIG. 14, the stator 36XC and the damper member 47A (mass body) are disposed on the base member (not shown) on the floor FL such that the stator 36XC and the damper member 47A can smoothly move. The frame member 43C (frame) is fixed to the floor FL. The stator 36XC and the damper member 47A are connected to each other via the coil spring 46A, and the stator 36XC and the frame member 43C are connected to each other though the coil spring 50A in parallel to the coil spring 46A. In this embodiment, the mass M2 of the damper member 47A is much smaller than the mass M1 of the stator 36XC, and the mass M2 is set to a few tens of kg. In this structure also, the high frequency component of vibration of the stator 36XC is attenuated by the stator 36XC and the damper member 47A, and mainly low frequency component of vibration is added to the frame member 43C. Therefore, influence of vibration caused by the reaction force generated by the linear motor 44XA is reduced by the simple mechanism.

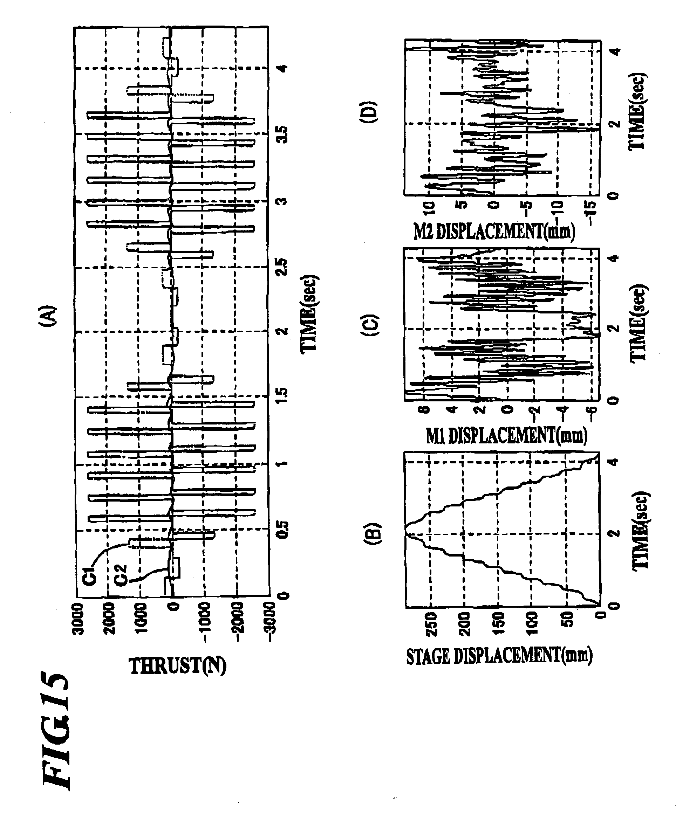

FIGS. 15 show one example of a simulation result of the filtered reaction mass type vibration attenuation mechanism shown in FIG. 14. FIGS. 15(A), (B), (C) and (D) correspond to FIGS. 13(A), (B), (C) and (D). In this case, however, the simulation was carried out under conditions that the leaked thrust C2 became slightly smaller that that of the example shown in FIG. 13 and the displacement amount of the stator 36XC became about ± 8 mm. In this simulation also, since the frequency component of the displacement (displacement of M2) of the damper member 47A is lower than displacement (displacement of M1) of the stator 36XC, it can be found that the stator 36XC and the damper member 47A function as low pass filters and the vibration is attenuated.

Referring back to FIG. 2, a member such as the frame member 43C (frame) is not connected to the damper members 47B and 47C, but the influence of vibration caused by a reaction force when the linear motors 44YA and 44XB are driven can be reduced only by providing the damper members 47B and 47C (mass bodies).
In this embodiment, the Y-axis guide 33Y and the X-axis guide 33X are disposed such that they intersect with each other and the Y-axis guide 33Y and the X-axis guide 33X are driven by linear motors 44XA, 44XB and 44YA and 44YB (coarse motion mechanisms) on both ends of the guides. Therefore, since it is unnecessary to incorporate the coarse motion mechanisms into the sliders 39 and 40, the movable section including the sliders 39 and 40 and the wafer stage WST can be reduced in size and weight. It is also possible to omit the X-axis guide 33X and the X-axis slider 40, and to provide a linear motor of Y-axis between the Y-axis guide 33Y and the Y-axis slider 39. In this structure, the Z leveling mechanism 55 can be connected to the Y-axis slider 39 at two locations.

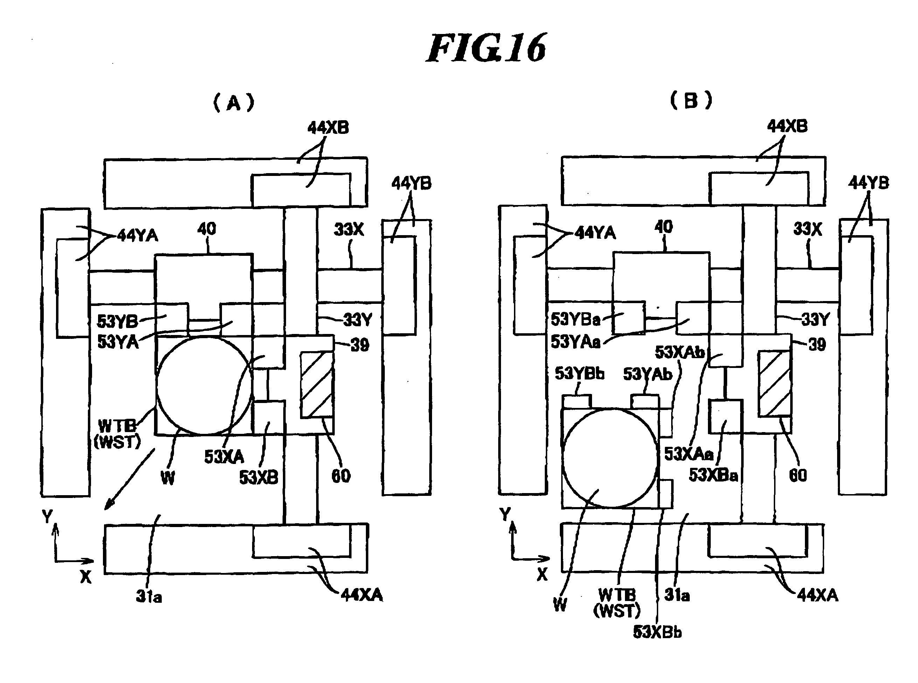

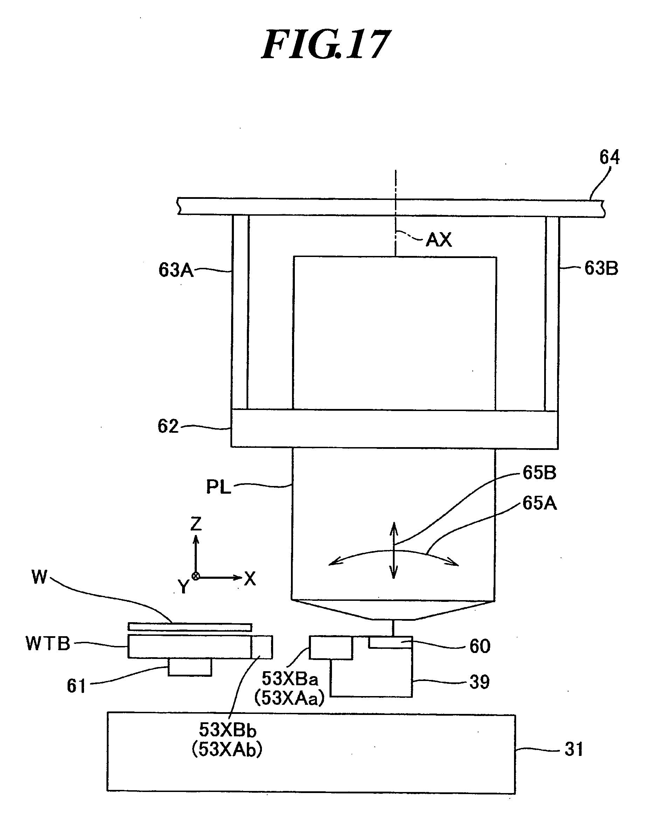

[Second embodiment] Next, a second embodiment of the invention will be explained with reference to FIGS. 16 and 17. A projection exposing apparatus of the second embodiment corresponds to the projection exposing apparatus shown in FIGS. 1 and 2 to which a mechanism for diagnosing or monitoring the state of the projection optical system PL is added. In FIGS. 16 and 17, portions corresponding to FIGS. 1, 2 and 8 are designated with the same symbols, and detailed explanation thereof will be omitted.

FIG. 16 (A) is a schematic plan view showing a wafer stage system of the projection exposing apparatus of the embodiment. In FIG. 16(A), the Y-axis guide 33Y and the X-axis guide 33X (guide members) are disposed such that they intersect with each other at right angles. The Y-axis slider 39 and the X-axis slider 40 (sliders) are connected to each other via a connecting member (not shown) such that they can move along the Y-axis guide 33Y and the X-axis guide 33X. The wafer stage WST which holds the wafer W is connected to the sliders 39 and 40. The Y-axis guide 33Y is driven by the linear motors 44XA and 44XB of the X-axis in the X direction, and the X-axis guide 33X is driven in the Y direction by the linear motors 44YA and 44YB of the Y-axis. With this, the sliders 39 and 40 and the wafer stage WST are integrally driven in the X direction and Y direction.

A diagnosing section 60 is disposed on an upper surface of the Y-axis slider 39 such that this upper surface is substantially at the same height as that of a surface (exposing surface) of the wafer W. A sensor or the like which measures a best focus position in a plurality of measuring points in the exposing region of the projection optical system PL shown in FIG. 1 is incorporated in the diagnosing section 60. The inclination angle of an image surface of the projection optical system PL and the best focus position can be obtained from the best focus position in the plurality of measuring points.

The wafer table WTB which holds the wafer W in the wafer stage WST is connected to the Y-axis slider 39 via two voice coil motor type X-axis actuators 53XA and 53XB, and is connected to the X-axis slider 40 via two voice coil motor type Y-axis actuators 53YA and 53YB. It is possible to control the position of the wafer table WTB in the X direction and Y direction and the rotation angle around the Z-axis also by using the four axes actuators. As shown in FIG. 8, the voice coil motor type actuators 53XA, 53XB, 53YA and 53YB can easily separate the movable element from the stator. That is, the wafer table WTB of the embodiment is attachable to and detachable from the sliders 39 and 40.

FIG. 16 (B) shows a state in which the wafer table WTB is separated from the sliders 39 and 40. In FIG. 16(B), the actuators 53XA, 53XB, 53YA and 53YB are separated into stators 53XAa, 53XBa, 53YAa and 53YBa on the side of the sliders 39 and 40, and into movable elements 53XAb, 53XBb, 53YAb and 53YBb on the side of the wafer table WTB. By separating the wafer table WTB in this manner, it is possible to measure an image surface of the projection optical system PL and to exchange wafers W on the wafer table WTB at the same time and efficiently. In an immersion exposing apparatus in which a space between the projection optical system PL and the wafer W is filled with liquid and a pattern is exposed on a wafer W, if liquid is supplied to and collected from between the projection optical system PL and the diagnosing section 60 during exchanging the wafers W, a so-called water mark is not generated and throughput is not deteriorated.

FIG. 17 is a front view of an essential portion of the projection exposing apparatus of the embodiment in the state shown in FIG. 16 (B). In FIG. 17, the wafer table WTB is extended on a predetermined arm 61 as one example. In this case, the Z leveling mechanism 55 in FIG. 2 may be left connected with the sliders 39 and 40. The Z leveling mechanism 55 may be separated from the sliders 39 and 40.

In FIG. 17, the projection optical system PL of the embodiment is suspended and supported from a predetermined column 64. That is, a flange 62 is fixed to a side surface of the projection optical system PL, and the flange 62 is suspended from the column 64 via three connecting members 63A and 63B (third connecting member is not shown). According to this structure, there is an adverse possibility that the optical axis AX of the projection optical system PL is deviated. Hence, the projection exposing apparatus of the embodiment is provided with a mechanism (not shown) which finely adjusts the inclination angle of the projection optical system PL. As shown in FIG. 17, the diagnosing section 60 on the Y-axis slider 39 is moved to an exposing region of the projection optical system PL, the inclination angle of the image surface of the projection optical system PL and the average best focus position are measured as described above and then, the inclination angle of the projection optical system PL is adjusted such that the image surface is in parallel to the XY plane. A measured value of the focus positions of the auto-focus sensors (23A and 23B) shown in FIG. 1 is offset adjusted so that the exposing operation is carried out at the measured best focus position. With this, when the wafer table WTB is connected to the sliders 39 and 40 and exposing operation is carried out next, the exposed surface of the wafer W on the wafer table WTB can match with the image surface of the projection optical system PL with high precision.

### [Third embodiment]

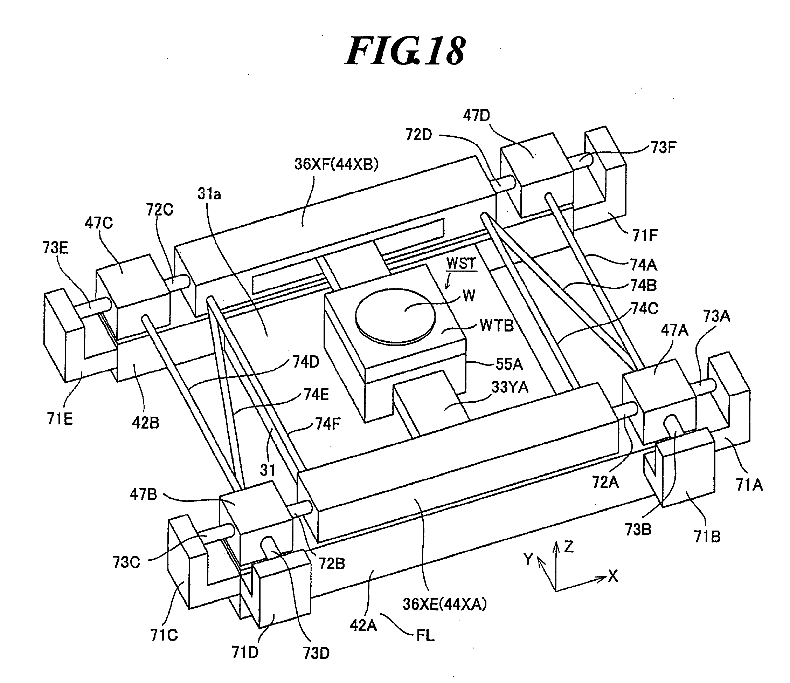

Next, a third embodiment of the invention will be explained with reference to FIG. 18. A projection exposing apparatus of this embodiment includes a filtered reaction mass type vibration attenuation mechanism like the first embodiment. In FIG. 18, portions corresponding to FIG. 2 are designated with the same symbols, and detailed explanation thereof will be omitted.

FIG. 18 is a schematic view of a structure of the wafer stage system of the projection exposing apparatus. In FIG. 18, base members 42A and 42B are disposed on the floor FL (disposing surface) such as to sandwich the wafer base 31 in the Y direction. In this embodiment also, the wafer base 31 and the base members 42A and 42B may be integrally formed together. A Y-axis guide 33YA having a stator of a linear motor is disposed above a guide surface 31a of the wafer base 31 substantially in parallel to the Y-axis . A Z leveling mechanism 55A is disposed such that the Z leveling mechanism 55A can move in the Y direction along the Y-axis guide 33YA. The wafer table WTB which holds a wafer W is fixed to the Z leveling mechanism 55A. The wafer table WTB and the Z leveling mechanism 55A constitute the wafer stage WST (movable stage). The Z leveling mechanism 55A of this embodiment can smoothly move on the guide surface 31a via an air bearing. The Z leveling mechanism 55A includes a mechanism which controls the position of the wafer table WTB in the Z direction and the inclination angle around the X-axis and Y-axis, and a movable element of a linear motor of Y-axis for driving the Z leveling mechanism 55A in the Y direction along the Y-axis guide 33YA.

Stators 36XE and 36XF of a linear motor are disposed on base members 42A and 42B such that the stators can move in the X direction along a straight guide (not shown) (or a magnet truck which is a guide in which a magnet is disposed) in parallel to the X-axis. A movable element (not shown) of the Y-axis guide 33YA and the stators 36XE and 36XF constitute linear motors 44XA and 44XB (driving devicees) of X-axis for driving the Y-axis guide 33YA and the wafer stage WST in the X direction. The two stators 36XE and 36XF are connected with each other at their both ends in the X direction by two rods 74C and 74F (connecting members) which are substantially in parallel to the Y-axis. With this, when the linear motors 44XA and 44XB are driven, since the two stators 36XE and 36XF are moved in association with each other by the reaction force, it is possible to prevent only one of the stators 36XE and 36XF from largely moving.

Two damper members 47A and 47B (mass bodies) are disposed such as to sandwich the one stator 36XE in the moving direction (X direction), and two damper members 47C and 47D (mass bodies) are disposed such as to sandwich the other stator 36XF in the moving direction (X direction). A total mass (M2) of both the damper members 47A and 47B is set smaller than a mass (M1) of the stator 36XE, and a total mass (M2) of both the damper members 47C and 47D is also set smaller than the mass (M1) of the stator 36XF. The damper members 47A to 47D of the embodiment are disposed on the base member 42A or 42B via ball bearings for example. Therefore, the damper members 47A to 47D can smoothly move in two directions, i.e., the X direction and Y direction. Further, the two damper members 47A and 47D in the + X direction are connected to each other via the rod 74A (connecting member) which is substantially in parallel to the Y-axis, and the two damper members 47B and 47C in the - X direction are connected to each other via the rod 74D (connecting member) which is substantially in parallel to the Y-axis. With this, since the two damper member 47A and 47D and the two damper members 47B and 47C can move in association with each other, it is possible to prevent a displacement amount of a specific one of the damper members 47A to 47D from increasing.

The stator 36XF and the damper member 47A are connected to each other via a mechanical filter member 74B, and the stator 36XF and the damper member 47B are connected to each other via a mechanical filter member 74E. Each of the mechanical filter members 74B and 74E is a member which is provided at its portion with a coil spring and which can expand and contract to some extent in the longitudinal direction. The mechanical filter members 74B and 74E function as low pass filters with respect to vibration. With this, the vibration of the stator 36XF (and stator 36XE) is further suppressed.

Frame members 71A and 71B (frames) are fixed to a side surface of the base member 42A such as to be opposed to the + X direction and - Y direction of the damper member 47A, and frame members 71C and 71D (frames) are fixed to a side surface of the base member 42A such as to be opposed to the - X direction and - Y direction of the damper member 47B. Similarly, frame members 71E and 71F (frames) are fixed to the base member 42B such as to be opposed to the - X direction of the damper member 47C and + X direction of the damper member 47D. The stator 36XE and the damper member 47A and 47B are connected to each other via mechanical filter members 72A and 72B (first connecting members) comprising coil springs, the damper member 47A and the frame members 71A and 71B are connected to each other via mechanical filter members 73A and 73B (second connecting members) comprising coil springs, and the damper member 47B and the frame members 71C and 71D are connected to each other via mechanical filter members 73C and 73D (second connecting members) comprising coil springs. The stator 36XF and the damper members 47C and 47D are connected to each other via mechanical filter members 72C and 72D (first connecting members) comprising coil springs, and the damper members 47C and 47D and the frame members 71E and 71F are connected to each other via the mechanical filter members 73E and 7eF (second connecting members) comprising coil springs.

In this embodiment also, when the Y-axis guide 33YA is driven by the linear motors 44XA and 44XB to move the wafer stage WST in the X direction, the stators 36XE and 36XF move in the opposite directions from each other by the reaction force. By the movements of the stators 36XE and 36XF, the damper members 47A to 47D move substantially in the same direction, but vibration of high frequency component of about 40 Hz or higher is attenuated during this time, and low frequency component lower than this high frequency component is released to the floor FL via the frame members 7A, 71C, 71E and 71F and the base members 42A and 42B. High frequency component of vibration in the Y direction caused by a difference of reaction forces of the stators 36XE and 36XF is also attenuated by the damper members 47A to 47D, and remaining low frequency component is released to the floor FL via the frame members 71B and 71D and the base member 42A. Therefore, influence of vibration when the linear motors 44XA and 44XB are driven is reduced.

The projection exposing apparatus of the embodiment is produced by an illumination optical system and a projection optical system comprising a plurality of lenses are incorporated in an exposing apparatus body, optical adjustment is carried out, a reticle stage and a wafer stage comprising a large number of mechanical parts are mounted on the exposing apparatus body, wirings and pipes are connected, and the projection exposing apparatus is adjusted in a comprehensive manner (electrical adjustment and validation of movement. It is preferable that the projection exposing apparatus is produced in a clean room where the temperature and the cleaning degree are managed.

When a semiconductor device is to be produced using the projection exposing apparatus of the embodiment, the semiconductor device is produced via a step for designing function and performance of the device, a step for producing a reticle based on the former step, a step for forming a wafer from silicon material, a step for carrying out alignment of the projection exposing apparatus of the embodiment and a pattern of the reticle is exposed on the wafer, a step for forming a circuit pattern such as etching, a step for assembling the device (including a dicing step, a bonding step and a packaging step), and an inspecting step.

The present invention cal also be applied to an immersion exposing apparatus disclosed in International Patent Application Publication Laid-open No. 99/49504. The invention can also be applied to a projection exposing apparatus using extreme ultraviolet light (EUV light) having wavelength of about a few nm to 100 nm as exposure beam.
The invention is not limited to the application to the exposing apparatus for producing a semiconductor device, and the invention can widely be applied to an exposing apparatus for a liquid crystal display device formed on an angular glass plate, or an display device such as a plasma display, an image capturing device (CCD or the like), a micromachine, a thin film magnetic head, and an exposing apparatus for producing various devices such as a DNA chip. Further, the invention can also be applied to an exposure step (exposing apparatus) when a mask (photomask, reticle and the like) formed with a mask pattern of various devices is produced using a photolithography step.

The invention is not limited to the above-described embodiments, and various structures can be employed within a range not departing from the subject matter of the invention of course. All of disclosed contents in Japanese Patent Application No.2004-244397 filed on August 24, 2004 including the specification, patent claims, drawings and the abstract are incorporated herein by reference.

### Industrial Applicability

According to the exposing apparatus of the present invention, it is possible to reduce the manufacturing costs, to enhance the vibration isolation performance, or to enhance the apparatus performance (exposing precision and the like) by using the stage apparatus in which the flexible structure is employed.

## Claims

1. A stage apparatus which drives an object, **characterized by** comprising:
a base member;
a first guide member disposed along a guide face of the base member;
a second guide member disposed along the guide face so as to intersect with the first guide member;
first and second sliders disposed such that the first and second sliders can move along the first and the second guide members, respectively;
a connecting member having a flexible structure to connect the first and the second sliders to each other; and
a movable stage which is to hold the object and is movably disposed on the guide face, and which is connected to the first and the second sliders.

2. The stage apparatus according to claim 1, **characterized in that** the connecting member includes a rod member having a flexure mechanism.

3. The stage apparatus according to claim 1 or 2, **characterized in that** the first and the second sliders are cylindrical members respectively mounted on the first and the second guide members.

4. The stage apparatus according to any one of the claims 1 to 3, **characterized by** further comprising:
first and second drive mechanisms which respectively drive the first and the second guide members in directions intersecting with each other; and
a fine motion mechanism which finely moves at least a portion of the movable stage with respect to the first and the second sliders.

5. The stage apparatus according to any one of the claims 1 to 4, **characterized in that** the first and the second guide members are of hollow structures.

6. A stage apparatus which drives an object, **characterized by** comprising:
a base member;
a guide member disposed along a guide face of the base member;
a slider disposed such that the slider can move along the guide member;
a movable stage which is to hold the object and can move in a direction intersecting with the guide face; and
a connecting member having a flexible structure to connect the slider and the movable stage.

7. The stage apparatus according to claim 6, **characterized in that**
the movable stage includes three drive members which drive to positions in directions intersecting with the guide face independently of each other, and a table section which is to hold the object supported by the three drive members, and
the connecting member connects the slider and two of the three drive members.

8. The stage apparatus according to claim 7, **characterized in that** the table section is supported in a floating manner above the drive member via a gas layer by a gas bearing mechanism incorporated in the drive member.

9. The stage apparatus according to claim 7 or 8, **characterized in that** the three drive members are connected to each other via a connecting mechanism having a structure more flexible than the drive members.

10. The stage apparatus according to any one of the claims 7 to 9, **characterized in that** the table section is made of a material having a specific rigidity higher than that of the guide member.

11. The stage apparatus according to any one of the claims 6 to 10, **characterized by** further comprising:
a drive mechanism which drives the guide member along the guide face; and
a fine motion mechanism which finely moves at least a portion of the movable stage with respect to the slider.

12. A stage apparatus which drives an object **characterized by** comprising:
a base member mounted on an installation face;
a movable stage which is to hold the object and which is movably disposed on a guide face of the base member;
a driving device which drives the movable stage, the driving device including a movable element connected to the movable stage and a stator which is movably supported;
a frame which is provided independently of the base member and which receives a reaction force generated when the movable stage is driven;
a mass body which is disposed between the stator and the frame and which can move;
a first connecting member which connects the stator and the mass body; and
a second connecting member which connects the mass body and the frame.

13. The stage apparatus according to claim 12, **characterized in that** the stator is disposed on the base member.

14. The stage apparatus according to claim 12 or 13, **characterized in that** the mass body is disposed on the base member.

15. The stage apparatus according to any one of the claims 12 to 14, **characterized in that** at least one of the first and the second connecting members include a coil spring.

16. The stage apparatus according to any one of the claims 12 to 15, **characterized in that** a mass of the stator is heavier than a mass of the mass body.

17. The stage apparatus according to any one of the claims 12 to 16, **characterized in that**
the stators are disposed at two locations so as to sandwich the movable stage, and
the stators at the two locations are connected.

18. A stage apparatus which drives an object **characterized by** comprising:
a base member;
a hollow guide member disposed along a guide face of the base member;
a slider disposed such that the slider can move along the guide member; and
a movable stage which is to hold the object and which is disposed on the guide face such that the movable stage can move, and which is connected to the slider.

19. An exposing apparatus which transfers and exposes a pattern onto a substrate via a projection system, **characterized in that** the substrate is driven using the stage apparatus according to any one of claims 1 to 18.

20. A stage apparatus which drives an object **characterized by** comprising:
a base member;
a movable stage which is to hold the object and which can move on the base member;
a first guide member which is disposed on a guide face of the base member along a first side face of the movable stage;
a first slider movably disposed along the first guide member; and
a first driving device which drives the movable stage in a first direction, the first driving device including a first stator provided at the first slider, and a first moving element provided at the movable stage.

21. The stage apparatus according to claim 20, **characterized in that** the first moving element is provided on the first side face.

22. The stage apparatus according to claim 20, **characterized by** comprising:
a second guide member disposed on a guide face of the base member along a second side face which intersects with the first side face of the movable stage at a right angle;
a second slider disposed such that the second slider can move along the second guide member; and
a second driving device which drives the movable stage in a second direction intersecting with the first direction at a right angle, the second driving device including a second stator provided at the second slider, and a second movable element provided at the movable stage.

23. The stage apparatus according to claim 20, **characterized in that** the second movable element is provided on the second side face.

24. The stage apparatus according to claim 20, **characterized by** comprising a third driving device which is connected to the first slider and which drives the movable stage in a direction intersecting with the guide surface.

25. The stage apparatus according to claim 22, **characterized by** comprising a third driving device which is connected to the second slider and which drives the movable stage in a direction intersecting with the guide surface.

26. The stage apparatus according to claim 20, **characterized by** comprising a fourth driving device which drives the first guide member in the first direction.

27. The stage apparatus according to claim 22, **characterized by** comprising a fifth driving device which drives the second guide member in the second direction.
